# EUROPEAN PATENT APPLICATION

(11) **EP 1 895 032 A2**
(43) Date of publication of application: **05.03.2008**
(21) Application number: 07253436.5
(22) Date of filing: 31.08.2007
(51) Int. Cl.: D01F 9/00, D01F 11/08, H01M 2/16, H05K 1/03

(54) **Silicone-based fiber, nonwoven fabric formed therefrom, and methods of producing same**

(30) Priority: 01.09.2006 JP 2006238313; 01.09.2006 JP 2006238316; 01.09.2006 JP 2006238186
(71) Applicant: Shin-Etsu Chemical Co., Ltd., Tokyo (JP)
(72) Inventor: Aoki, Yoshitaka, Annaka-shi, Gunma-ken (JP)
(74) Representative: Hallybone, Huw George

(57) **Abstract**

A fiber formed of a non-melting solid silicone having an elemental composition represented by a formula (1) is provided. A nonwoven fabric formed of the fiber is also provided.

SiCₐH_{b}O_{c} (1)

wherein a is a number that satisfies: 0.5 ≤ a ≤ 7.0, b is a number that satisfies: 0.5 ≤ b ≤ 8.0, and c is a number that satisfies 1.0 ≤ c ≤ 3.0. The fiber is useful as modifiers for various synthetic resins. The fiber and nonwoven fabric are useful as a reinforcing material for composite materials.

## Description

### BACKGROUND OF THE INVENTION

### 1. Field of the invention

The present invention relates to a silicone-based fiber, a nonwoven fabric formed therefrom, methods of producing the fiber and nonwoven fabric, and applications of the fiber and nonwoven fabric.

### 2. Description of the Prior Art

Fine particles of polyorganosilsesquioxanes are used as a variety of modifiers for various materials, such as, e.g., slipperiness-imparting agents, abrasion resistance-imparting agents and light diffusion-imparting agents for synthetic resins; anti-blocking agents for plastic films; slipperiness-imparting agents for rubbers; surface slipperiness-imparting agents for coating agents; and as extensibility-imparting agents, surface slipperiness-imparting agents and water repellency-imparting agents for cosmetics and waxes, and as abrasiveness-imparting agents for cleaning agents (patent reference 1). However, silicone resin fibers that can be used as these modifiers have until now been unknown.

Furthermore, conventionally, glass fiber and carbon fiber have been the most widely known reinforcing materials for composite materials. In particular, carbon fiber reinforced plastic (CFRP) that uses carbon fiber exhibits superior levels of strength and elastic modulus when compared with steel or glass fiber reinforced plastic (GFRP), and also offers superior mechanical properties. However, these inorganic fibers exhibit poor wetting properties relative to the material being reinforced, and silane coupling agents are widely used to address this problem (patent references 2 and 3).

Conventionally, the substrates for electrically insulating laminates such as printed wiring boards, the substrates for construction materials including tile carpets, and the separators for solid electrolytic capacitors have used glass paper.

However, due to the properties of glass, the glass fiber used for forming the glass paper is prone to cracking upon application of external pressure, meaning the molding of glass paper into a desired shape such as a circular cylinder has proven difficult. In order to increase the mechanical strength of glass paper, it is desirable that the glass fiber constituting the glass paper is disentangled to form individual monofilaments. However, because glass fiber exhibits poor compatibility with white water, the rate of this disentanglement to form monofilaments within white water is slow. Furthermore, the melting point of glass is high, and reducing the diameter of glass fiber is difficult, meaning generating glass paper as a thin film is very difficult. For these reasons, glass paper is unsuited to uses within printed wiring boards, which are incorporated within electronic equipment that demands miniaturization and multifunctionality.

In order to overcome these problems, silane coupling agents have been used (patent reference 4). Furthermore, short glass fibers with a softening point of 900°C or lower have also been used (patent reference 5). However, because these materials are short fibers, the material strength tends to be low, and the solvent resistance and heat resistance also tend to be unsatisfactory.
[Patent Reference 1] JP 2002-241513 A
[Patent Reference 2] JP 5-170953 A
[Patent Reference 3] EP 0436198 A2
[Patent Reference 4] JP 9-235332 A
[Patent Reference 5] JP 2005-109012 A

### SUMMARY OF THE INVENTION

The present invention takes the circumstances described above into consideration, with an object of providing a novel silicone-based fiber that is ideal as modifiers for various materials, as an extensibility-imparting agent, surface slipperiness-imparting agent and water repellency-imparting agent for cosmetics and waxes, as an abrasiveness-imparting agent for cleaning agents, and also as a reinforcing material for a composite material that exhibits superior levels of heat resistance, wettability, strength and elastic modulus, as well as providing a method of producing such a silicone-based fiber.

Furthermore, taking the circumstances described above into consideration, the present invention also has an object of providing a silicone nonwoven fabric that exhibits superior levels of crack resistance, solvent resistance and heat resistance, which can be used favorably as a substrate for printed wiring boards, a construction material such as a tile carpet, a separator for solid electrolytic capacitors, and a separator for fuel cells, as well as providing a method of producing such a nonwoven fabric.

The inventors of the present invention discovered that the above objects could be achieved by the inventions described below.

In other words, a first aspect of the present invention, which resolves the problems described above, provides a fiber formed of a non-melting solid silicone in which a composition of elements is represented by a formula (1):

SiCₐH_{b}O_{c} (1)

(wherein, a is a number that satisfies: 0.5 ≤ a ≤ 7.0, b is a number that satisfies: 0.5 ≤ b ≤ 8.0, and c is a number that satisfies 1.0 ≤ c ≤ 3,0) (hereinafter, referred to as "non-melting solid silicone fiber").

The present invention provides, as a preferred embodiment of the non-melting solid silicone fiber, a fiber of a non-melting silicone resin (also referred to as the "silicone fiber (1)"), in which the composition of elements is represented by the formula (1) stated above.

The present invention also provides, as another preferred embodiment, a cured silicone fiber (also referred to as the "silicone fiber (2)") formed of the cured product of a curable silicone composition wherein the cured product has the composition of elements represented by the formula (1) stated above.

A second aspect of the present invention provides, as a production method for the above-stated non-melting solid silicone fiber, a method of producing the above non-melting silicone resin fiber (the silicone fiber (1)), comprising the steps of:
melt spinning a meltable silicone resin to obtain a meltable silicone resin fiber, and
subjecting the meltable silicone resin fiber to a non-melting treatment.

In addition, yet another aspect of the present invention provides, as another production method for the above-stated non-melting solid silicone fiber, a method of producing the cured silicone fiber (the silicone fiber (2)), comprising the steps of:
continuously extruding a curable silicone composition which is liquid at room temperature through an aperture to form a fiber of the curable silicone composition,
drawing out the fiber of the curable silicone composition, and
curing the fiber of the curable silicone composition while the fiber is drawn out.

The inventors of the present invention also discovered that a nonwoven fabric formed of the non-melting solid silicone fiber obtained from the above non-melting solid silicone was able to achieve the objects described above.

Thus, another aspect of the present invention provides a silicone nonwoven fabric formed of the non-melting solid silicone fiber,

In the present specification, the term "nonwoven fabric" refers to any known nonwoven fabrics including bonded fabrics, felt, etc.

The present invention provides, as a preferred embodiment of said nonwoven fabric, a silicone nonwoven fabric (also referred to as the "silicone nonwoven fabric (1)") formed of the aforementioned silicone resin fiber (the silicone fiber (1)).

Moreover, the present invention also provides, as another preferred embodiment of said nonwoven fabric, a silicone nonwoven fabric (also referred to as the "silicone nonwoven fabric (2)" formed of the aforementioned cured silicone fiber (the silicone fiber (2)).

The present invention also provides a method (dry method)of producing the silicone nonwoven fabric (1), as a silicone nonwoven fabric according to the present invention, comprising the steps of: melt spinning a meltable silicone resin to form a meltable silicone resin fiber, subjecting the meltable silicone resin fiber to suction collection on a receiver to form a nonwoven fabric, and subsequently subjecting the nonwoven fabric to a non-melting treatment.

The present invention also provides another method (wet method) of producing the silicone nonwoven fabric (1), as a silicone nonwoven fabric according to the present invention, comprising the steps of: melt spinning a meltable silicone resin to obtain a meltable silicone resin fiber, subjecting the meltable silicone resin fiber to a non-melting treatment to produce a non-melting silicone resin fiber, dispersing the thus obtained non-melting silicone resin fiber in an aqueous medium containing a binder to prepare a slurry, and producing a nonwoven fabric from the slurry using a papermaking process.

The present invention also provides a method (dry method) of producing the silicone nonwoven fabric (2), as a silicone nonwoven fabric according to the present invention, comprising the steps of:
continuously extruding a curable silicone composition which is liquid at room temperature through an aperture to form a fiber of the curable silicone composition,
drawing out the fiber of the curable silicone composition, and
curing the fiber of the curable silicone composition while the fiber is drawn out, to obtain a cured silicone fiber,
subjecting the cured silicone fiber to suction collection on a receiver.

The present invention also provides another method (wet method) of producing the silicone nonwoven fabric (2), comprising the steps of:
continuously extruding a curable silicone composition which is liquid at room temperature through an aperture to form a fiber of the curable silicone composition,
drawing out the fiber of the curable silicone composition, and
curing the fiber of the curable silicone composition while the fiber is drawn out, to obtain a cured silicone fiber,
dispersing the cured silicone fiber within an aqueous medium containing a binder to prepare a slurry, and
producing a silicone nonwoven fabric from the slurry using a papermaking process.

The present invention also relates to applications of the non-melting solid silicone fiber described above, and provides a composite material, comprising either one of, or both, a metal material and a polymer material, together with the above non-melting solid silicone fiber as a reinforcing material.

Moreover, the present invention also relates to applications of the non-melting solid silicone fiber described above, and provides a substrate for a printed wiring board, a tile carpet or other construction material, a separator for a solid electrolytic capacitor, and a separator for a fuel cell, all comprising an aforementioned silicone nonwoven fabric.

A non-melting solid silicone fiber of the present invention can be used favorably modifiers for various materials, for example, as a slipperiness-imparting agent, abrasion resistance-imparting agent and light diffusion-imparting agent for synthetic resins, as an anti-blocking agent for plastic films, as a slipperiness-imparting agent for rubbers, as a surface slipperiness-imparting agent for coating agents, as an extensibility-imparting agent, surface slipperiness-imparting agent and water repellency-imparting agent for decorative products and waxes, as an abrasiveness-imparting agent for cleaning agents, and also as a reinforcing material for a composite material that exhibits superior levels of heat resistance, wettability, strength and elastic modulus. Furthermore, a production method of the present invention enables the production of this type of non-melting solid silicone fiber. Moreover, a non-melting solid silicone fiber of the present invention is also useful as an intermediate material for producing a silicon-containing inorganic In other words, by heating the non-melting solid silicone fiber under a non-oxidizing atmosphere, a silicon-containing inorganic fiber can be obtained, and this inorganic fiber is also useful as a reinforcing material for metals and polymers.

As described above, because a silicone nonwoven fabric of the present invention exhibits superior levels of crack resistance, solvent resistance and heat resistance, it can be used favorably as a substrate for a printed wiring board, a tile carpet or other construction material, a separator for a solid electrolytic capacitor, and a separator for a fuel cell or the like. Furthermore, a production method of the present invention enables the production of this type of silicone nonwoven fabric. Moreover, heating and calcining the silicone nonwoven fabric of the present invention under a non-oxidizing atmosphere yields a nonwoven fabric that is useful as an intermediate material for producing an amorphous inorganic ceramicized nonwoven fabric that can be used as an alternative to carbon fiber-based nonwoven fabrics.

### BRIEF DESCRIPTION OF THE DRAWINGS

Fig. 1 is a schematic diagram describing a method of producing a silicone nonwoven fabric (1) of the present invention using a dry method.
Fig. 2 is a schematic diagram describing a method of producing a silicone nonwoven fabric (2) of the present invention using a dry method.

### DETAILED DESCRIPTION OF THE PREFERRED EMBODIMENTS

As follows is a more detailed description of the present invention.

In this specification, the term "solid silicone" refers to a silicone that is solid at room temperature. A silicone is a polymer material with an organopolysiloxane base, and in some cases, may exist in the form of a composition that also includes other components such as a filler. Unless stated otherwise, room temperature refers to a temperature within a range from 15 to 35°C.

The term "silicone resin" refers to an organopolysiloxane having a three dimensional structure which comprises branched siloxane units (namely, trifunctional siloxane units known as T units and/or tetrafunctional siloxane units known as Q units) as essential siloxane units. In some cases, the silicone resin may also include straight-chain siloxane units known as D units and/or monofunctional siloxane units known as M units that are positioned at molecular chain terminals.

Furthermore, in this specification, a polymer material described as "non-melting" has no softening point, meaning that as the temperature is raised for a non-melting polymer material, the material does not melt, but rather undergoes thermal decomposition. Accordingly, a "non-melting solid silicone" refers to a solid silicone that has no softening point, and a "non-melting silicone resin" refers to a silicone resin that has no softening point. The temperature at which non-melting solid silicones undergo thermal decomposition typically exceeds a temperature of approximately 400°C.

In this specification, the "softening point" refers to a temperature measured in accordance with the softening point test method (ring and ball method) prescribed in JIS K 2207.

### [Non-melting Solid Silicone fiber and non-woven fabric formed thereof]

### - Non-melting Solid Silicone Fiber

The non-melting solid silicone fiber of the present invention has an elemental composition represented by the formula (1) stated above. Because the fiber has a high degree of three dimensional cross-linking, it does not melt, even at high temperatures.

The non-melting solid silicone fiber of the present invention typically has a diameter within a range from 0.1 to 50 µm, and preferably from 5 to 30 µm,

### - Silicone nonwoven fabric

The silicone nonwoven fabric according to the present invention is formed of the above-described non-melting solid silicone fiber.

Now, the silicone fibers (1) and (2), which are preferred embodiments of the non-melting solid silicone fiber according to the present invention, and the silicone nonwoven fabrics (1) and (2) formed thereof will be described.

### = Silicone fiber (1) and non-woven fabric formed thereof =

### - Non-melting Silicone Resin Fiber (Silicone fiber (1) )

The non-melting silicone resin fiber has an elemental composition represented by a formula (1):

SiCₐH_{b}O_{c} (1)

(wherein, a is a number that satisfies: 0.5 ≤ a ≤ 7.0, b is a number that satisfies: 0.5 ≤ b ≤ 8.0, and c is a number that satisfies 1,0 ≤ c ≤ 3.0). Because the fiber has a high degree of three dimensional cross-linking, it does not melt, even at high temperatures.

The above compositional formula (1) indicates that the average elemental ratio between silicon, carbon, hydrogen and oxygen within the non-melting silicone resin fiber is represented by 1:a:b:c. If a is smaller than 0.5, then the strength of the fiber is unsatisfactory. In contrast, if a is larger than 7.0, then the fiber is unsatisfactory from a heat resistance perspective. Furthermore, if b is smaller than 0.5, then the elastic modulus of the fiber is unsatisfactory, whereas if b is larger than 8.0, then the heat resistance of the fiber is unsatisfactory. If c is smaller than 1.0, then the material is undesirable from an economic perspective. In contrast, if c is larger than 3.0, then the strength of the fiber is unsatisfactory.

### - Method of Producing Silicone Fiber (1)

The non-melting silicone resin fiber (silicone fiber (1)) can be produced by a process comprising;
melt spinning a meltable silicone resin to obtain a meltable silicone resin fiber, and
subjecting the meltable silicone resin fiber to a non-melting treatment.

### - - Meltable Silicone Resin

A meltable silicone resin is used as a raw material within the above production method. Here, the term "meltable silicone resin" refers to a silicone resin that is a solid at room temperature, but has a softening point. In other words, as the temperature of the meltable silicone resin is raised, the resin either melts or softens at the softening point.

The meltable silicone resin used in a production method of the present invention preferably has a softening point that is at an ideal temperature for melt spinning. Specifically, as described below, melt spinning is usually conducted at a temperature within a range from 50 to 200°C, and in such cases the softening point of the meltable silicone resin is typically within a range from 40 to 150°C, and is preferably from 40 to 100°C. If the softening point is too high relative to the melt spinning temperature, then the fluidity of the silicone resin during melt spinning is poor, which, is undesirable.

Examples of the meltable silicone resin include, for example, the silicone resins represented by an average composition formula (2):

R¹ₘR²ₙ(OR³)ₚ(OH)_{q}SiO_{(4-m-n-p-q)/2} (2)

(wherein, each R¹ represents, independently, a hydrogen atom or a monovalent hydrocarbon group other than an aryl group that may be identical to, or different from, the other R¹ groups and may include a carbonyl group, R² represents an aryl group, R³ represents identical or different monovalent hydrocarbon groups of 1 to 4 carbon atoms, m represents a number that satisfies: 0.1 ≤ m ≤ 2, n represents a number that satisfies: 0 ≤ n ≤ 2, p represents a number that satisfies: 0 ≤ p ≤ 1.5, and q represents a number that satisfies: 0 ≤ q ≤ 0.35, provided that p+q > 0 and 0.1 ≤ m+n+p+q ≤ 2.6). Provided that the non-melting silicone resin fiber obtained by the non melting treatment is required to have the elemental composition represented by the above-stated formula (1). Since the elemental composition does not change substantially between before and after the non melting treatment, those skilled in the art can readily select a suitable meltable silicone resin meeting the requirement.

Each of the above R¹ groups preferably represents, independently, either a hydrogen atom, or a monovalent hydrocarbon group other than an aryl group that may be identical to, or different from, the other R¹ groups, may include a carbonyl group, and contains from 1 to 8 carbon atoms. Specific examples of R¹ include a hydrogen atom; alkyl groups such as a methyl group, ethyl group, propyl group, butyl group, pentyl group or hexyl group; cycloalkyl groups such as a cyclopentyl group or cyclohexyl group; alkenyl groups such as a vinyl group, allyl group, propenyl group, isopropenyl group or butenyl group; and acyl groups such as an acryloyl group or methacryloyl group. From the viewpoint of ease of availability of the raw material, R¹ is preferably a hydrogen atom, methyl group, ethyl group or vinyl group.

The aforementioned m is a number that satisfies; 0.1 ≤ m ≤ 2, the upper limit for m is preferably not more than 1.5, and the lower limit for m is preferably at least 0.1, and even more preferably 0.5 or greater. Provided the value of m falls within this range, the fluidity of the meltable silicone resin can be readily lowered, which improves the workability during melt spinning.

The aforementioned R² group is an aryl group, preferably a phenyl group, which increases the melting point of the meltable silicone resin, and contributes to improved workability during melt spinning.

The aforementioned n is a number that satisfies: 0 ≤ n ≤ 2, the upper limit for n is preferably not more than 1.5, and the lower limit for n is preferably at least 0.05, and even more preferably 0.1 or greater.

Specific examples of the aforementioned R³ group include alkyl groups of 1 to 4 carbon atoms such as a methyl group, ethyl group, propyl group, isopropyl group, butyl group or isobutyl group, and a methyl group is particularly preferred industrially.

The aforementioned p indicates the quantity of the hydrocarbyloxy groups represented by OR³ and is a number that satisfies: 0 ≤ p ≤ 1.5, the upper limit for p is preferably not more than 1.2, and the lower limit for p is preferably at least 0.05 and even more preferably 0.1 or greater.

The aforementioned q indicates the quantity of hydroxyl groups and is a number that satisfies: 0 ≤ q ≤ 0.35, and q is preferably a number that satisfies: 0 ≤ q ≤ 0.3, and is most preferably 0. The value of q represents the small quantity of residual hydroxyl groups retained within the meltable silicone resin during production. Provided the value of q falls within the above range, the reactivity of the hydroxyl groups can be favorably suppressed for the meltable silicone resin as a whole, and both the storage stability of the meltable silicone resin, and the stability and workability during melt spinning can be improved.

The value of p+q indicates the combined quantity of hydrocarbyloxy groups and hydroxyl groups, wherein p+q > 0. The hydrocarbyloxy groups (preferably alkoxy groups) and/or hydroxyl groups are necessary for forming cross-links via hydrolysis condensation reactions during the non-melting treatment described below. The combined total of these groups is preferably within a range from 1 to 15% by mass within the meltable silicone resin, and is even more preferably from 2 to 10% by mass.

The value of m+n+p+q is a number that satisfies: 0.1 ≤ m+n+p+q ≤ 2.6.

The molecular weight of the meltable silicone resin is preferably such that the resin has an appropriate softening point as described above. For example, the weight average molecular weight measured using gel permeation chromatography (hereafter abbreviated as GPC) and referenced against polystyrene standards is preferably at least 600, and is even more preferably within a range from 1,000 to 10,000.

The meltable silicone resin used in the present invention can be easily drawn out into a fiber having a diameter of not more than 50 µm, and preferably not more than 30 µm, using the method described below.

There are no particular restrictions on the meltable silicone resin provided it satisfies the conditions described above, although a silicone resin that includes methyl groups within its molecular structure is preferred. The meltable silicone resin may be either a single resin, or a combination of two or more resins with different molecular structures or different proportions of the various siloxane units.

These types of meltable silicone resins can be produced by conventional methods. For example, the target meltable silicone resin can be produced by conducting a cohydrolysis, if required in the presence of an alcohol of 1 to 4 carbon atoms, of the organochlorosilanes that correspond with the siloxane units incorporated within the structure of the target resin, using a ratio between the organochlorosilanes that reflects the ratio between the corresponding siloxane units, while removing the by-product hydrochloric acid and low boiling point components. Furthermore, in those cases where alkoxysilanes, silicone oils or cyclic siloxanes are used as starting raw materials, the target silicone resin can be obtained by using an acid catalyst such as hydrochloric acid, sulfuric acid or methanesulfonic acid, adding water to effect the hydrolysis if required, and following completion of the polymerization reaction, removing the acid catalyst and low boiling point components.

### - - Melt Spinning

In a production method of the present invention, in the first step, the meltable silicone resin described above is subjected to melt spinning to produce a silicone resin fiber. In the production method of the present invention, melt spinning is used,

Melt spinning can be conducted using conventional methods, and can be conducted, for example, using a monofilament spinning apparatus having an orifice diameter within a range from 100 µm to 1 mm, at a temperature within a range from 50 to 200°C. The melt spinning is conducted under an inert gas atmosphere of argon gas or nitrogen gas or the like, and is preferably conducted under an atmosphere of argon gas. The speed with which the fiber is wound onto the reel is typically within a range from 100 to 1,000 m/minute, and is preferably from 200 to 500 m/minute. The silicone resin fiber obtained from the melt spinning process has a diameter that typically falls within a range from 0.1 to 50 µm, and preferably from 0,5 to 30 µm.

An example of a preferred melt spinning method is the melt blow method. In this case, as above, the diameter of the fiber spinning nozzle from which the melted silicone resin is extruded, is preferably within a range from approximately 100 µm to 1 mm. In a melt blow method, a plurality of nozzles that blow heated gas in the same direction as the direction in which the melted fiber is extruded and drawn out are usually arranged around the periphery of the fiber spinning nozzle, so that the melted silicone resin extruded from the fiber spinning nozzle is insulated or heated for a predetermined distance. The blow speed of this heated gas is typically within a range from approximately 30 to 300 m/s, and faster speeds enable the production of finer fibers, The melt blow method is particularly advantageous for producing fibers of narrow fiber diameter.

### -- Non-melting Treatment

In a production method of the present invention, the silicone resin fiber obtained via the above melt spinning process is subjected to a non-melting treatment. Because the silicone resin fiber is meltable, it melts or softens upon exposure to high temperatures, but the fiber can be converted to a non-melting form by conducting the non-melting treatment. The non-melting treatment can be conducted, for example, by treating the meltable silicone resin fiber with an inorganic acid. The treatment with an inorganic acid causes a dehydration condensation between the residual hydrocarbyloxy groups and silanol groups within the meltable silicone resin fiber, thereby causing a cross-linking reaction that increases the density of three dimensional network structures. It is thought that this change results in the silicone resin developing non-melting properties. The non-melting fiber obtained from the non-melting treatment does not melt even at-higif temperatures, meaning individual fibers do not fuse together.

Examples of the inorganic acid used in the non-melting treatment described above include gaseous acids such as hydrogen chloride gas, and liquids such as hydrochloric acid and sulfuric acid. The nature and concentration of the inorganic acid can be selected appropriately in accordance with the quantity of phenyl groups incorporated within the silicone resin used as the raw material for the melt spun fiber. In those cases where the quantity of phenyl groups incorporated within the silicone resin is low, for example in those cases where the ratio of phenyl groups relative to the combined total of organic groups and hydroxyl groups bonded to silicon atoms within the silicone resin (hereafter, this ratio is referred to as the "phenyl group content") is within a range from 0 to 5 mol%, the use of hydrochloric acid with a concentration of not more than 50% by mass is preferred, the use of hydrochloric acid with a concentration of not more than 30% by mass is even more preferred, and the use of hydrochloric acid with a concentration of 10 to 25% by mass is particularly desirable. By using such an inorganic acid, siloxane equilibration reactions are less likely to occur during the non-melting treatment, meaning the shape of the fibers can be more readily maintained. In contrast, in those cases where the phenyl group content within the silicone resin is high, for example in cases where the phenyl group content exceeds 5 mol% but is not more than 25 mol%, the use of hydrogen chloride gas or sulfuric acid or the like is preferred. By using such an inorganic acid, the non-melting treatment reaction can proceed rapidly even in those cases where the large quantity of phenyl groups causes significant steric hindrance.

In those cases where a gaseous inorganic acid is used, the treatment with an inorganic acid can be conducted by bringing the melt spun fiber into contact with an atmosphere containing the inorganic acid, whereas in those cases where a liquid inorganic acid is used, the treatment can be conducted by immersing the melt spun fiber in the inorganic acid, The treatment temperature is typically within a range from 5 to 50°C, and is preferably from 10 to 30°C, and the non-melting treatment time is typically within a range from 10 to 50 hours.

The non-melting silicone resin fiber (silicone fiber (1)) described above constitutes the silicone nonwoven fabric (1). The nonwoven fabric can be produced, for example, using the methods described below.

### - Dry Production Method for Silicone Nonwoven Fabric (1)

According to a dry production method, the silicone nonwoven fabric (1) is obtained by a process comprising:
melt spinning a meltable silicone resin to form a meltable silicone resin fiber, causing the meltable silicone resin fiber to fall and subjecting the fiber to suction collection on a receiver to form a nonwoven fabric, and subsequently subjecting the nonwoven fabric to a non-melting treatment.

According to this method, a nonwoven fabric in a form of felt is obtained.

### (1) Melt Spinning of the Meltable Silicone Resin

Melt spinning of the meltable silicone resin is as described above.

### (2) Formation of a Nonwoven Fabric

By collecting the silicone resin fiber that has been melt spun in the manner described above on a receiver while applying suction, a nonwoven fabric comprising the fibers is formed. There are no particular restrictions on the direction in which the meltable silicone resin fiber is drawn out from the fiber spinning nozzle, with vertical, diagonal or sideways drawing all being suitable, and the receiver that receives the drawn fiber is positioned so as to be able to suitably intercept and collect the fiber being spun in the drawing direction. In a typical arrangement, drawing out is conducted in a vertical downward direction from the fiber spinning nozzle so that the fiber falls under the effects of gravity, and the receiver is positioned horizontally in a position directly below the fiber spinning nozzle. Regardless of positioning, suction is preferably conducted from behind the receiver. By conducting suction collection, the fibers become effectively intertwined with each other, yielding a nonwoven fabric with excellent strength. The suction speed is preferably within a range from 2 to 10 m/s.

There are no particular restrictions on the shape of, or the material used for, the receiver. Suitable shapes for the receiver include flat sheets, dish shapes, open containers, pouches, and belt shapes. Suitable materials for the receiver include metals, plastics, rubbers and glass. The height from the aperture of the above fiber spinning nozzle to the receiver varies depending on factors such as the temperature and humidity of the operating environment, and although there are no particular restrictions, is typically within a range from 20 to 150 cm. When executing the above method, the receiver is preferably moved continuously in a prescribed direction so that the nonwoven fabric is formed With a constant and uniform thickness on top of the receiver. In such cases, the travel speed of the receiver is typically within a range from 0.01 to 5 m/s, and is preferably from 0.05 to 2 m/s. An example of this type of moving receiver is the belt of a belt conveyor.

Suction collection of the curable silicone fiber on the surface of a receiver can be conducted by airflow or static electricity or the like, but is preferably conducted by airflow. In those cases where the suction collection is conducted by airflow, a receiver with an air permeable structure, e.g., a mesh structure is selected. The airflow is generated so as to flow from the upper surface of the receiver through to the rear surface, and this airflow is used to effect suction collection. In those cases where the suction collection is conducted by static electricity, a chargeable material is selected as the material for the receiver, and suitable materials include metals or plastics.

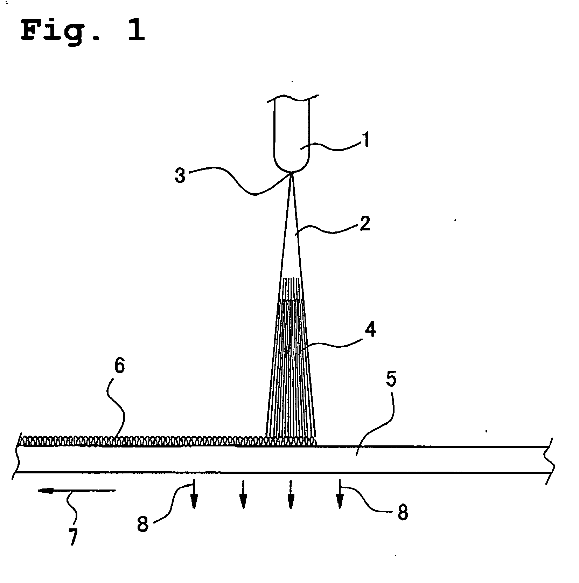

Fig. 1 is a schematic diagram showing an example of producing the silicone nonwoven fabric (1) using this dry method. A melted silicone resin 2 is supplied via a fiber spinning nozzle 1, and is extruded from a nozzle aperture 3 and falls vertically downward. The number of fiber spinning nozzles 1 may be either one, or a plurality. In the case of a plurality of fiber spinning nozzles 1, a multitude of positional arrangements are possible for the nozzles, although the arrangement is preferably such that a uniform quantity of the silicone fiber falls onto a fixed region of the receiver. For example, the tips of the nozzles 1 may be arranged along a horizontal line, at the same height and with a uniform spacing between nozzles, or may be arranged in a two dimensional pattern within a horizontal plane. In the case of a two dimensional arrangement, the arrangement pattern may be a circle, a series of two or more concentric circles, or a radial pattern.

Upon exiting the nozzle 1, the falling melted silicone resin 2 cools and solidifies through exposure to the outside atmosphere, thereby forming a meltable silicone resin fiber 4.

The meltable silicone resin fiber 4 reaches the surface of a belt 5 of a belt conveyor. An arrow 7 indicates the travel direction of the belt 5. The belt 5 has a structure that exhibits air permeability, and is formed from a metal, plastic or rubber or the like. By applying suction from beneath the belt 5, an airflow is generated which passes through the belt 5 from top to bottom in the direction of an arrow 8. The silicone resin fiber 4 that reaches the surface of the belt 5 is collected on top of the belt 5 by the suction generated by the downward airflow During this suction collection, the silicone resin fibers 4 become intertwined, so that a silicone nonwoven fabric 6 is formed continuously along the travel direction 7 of the belt 5.

In those cases where suction is not applied from beneath the belt 5, instead of a silicone nonwoven fabric 6 being formed, the silicone fiber 4 that reaches the surface of the belt 5 is collected in a cotton wool-like form on top of the belt 5. The cotton wool-like silicone resin collected in this manner can be subjected to a non-melting treatment, and then used to produce a nonwoven fabric by a papermaking process that employs an aqueous slurry produced via a wet method described below.

### (3) Non-melting Treatment

A non-melting treatment of the nonwoven fabric comprising the meltable silicone resin fiber obtained via the steps described above is then conducted, yielding a silicone nonwoven fabric (1) according to the present invention. Specific examples of the non-melting treatment are as described above.

### - Wet Production Method for Silicone Nonwoven Fabric (1)

According to a wet production method of the present invention, the silicone resin nonwoven fabric (1) can be obtained by a process comprising dispersing the non-melting silicone resin fiber obtained via the method described above within an aqueous medium containing a binder to prepare a slurry, and producing a nonwoven fabric from the slurry using a process that is essentially the same as a typical papermaking process.

According to this method, a nonwoven fabric is obtained as a bonded fabric.

Water is usually used as the aqueous medium, and an aqueous medium obtained by dissolving or dispersing a binder in water is suitably used. The binder used may be either an organic binder, an inorganic binder, or a combination of both type of binder. Examples of suitable organic binders include carboxymethylcellulose and polyvinyl alcohol. Examples of suitable inorganic binders include colloidal silica and colloidal alumina. The quantity of the binder is preferably as small as possible relative to the quantity of fiber, and specifically, is preferably not more than 3% by mass, typically within a range from 0.05 to 3% by mass, and even more preferably not more than 1% by mass, relative to the mass of fiber.

The concentration of the non-melting silicone resin fiber within the slurry is typically within a range from 0.1 to 50% by mass, and is preferably from 0.5 to 30% by mass.

The step of using a papermaking process to prepare a nonwoven fabric from the non-melting silicone resin fiber dispersed within the aqueous slurry may employ essentially the same techniques as those used during normal papermaking processes.

The diameter of the fiber within the silicone nonwoven fabric (1) is typically within a range from 0,1 to 50 µm, and is preferably from 0.5 to 30 µm, If the fiber diameter is less than 0.1 µm, then fiber production becomes difficult, whereas if the fiber diameter exceeds 50 µm, fiber aggregation is more likely to occur during the fiber spinning process, making production of the nonwoven fabric difficult.

### = Silicone Fiber (2) and Nonwoven Fabric (2) formed therefrom =

Next is a description of a silicone fiber (2) and silicone nonwoven fabric (2) obtained from a curable silicone composition.

First is a description of the curable silicone composition that functions as the starting material. The curable silicone composition is liquid at room temperature, preferably it has a viscosity at room temperature of from 100 to 1,000,000 mPa.s, and more preferably from 200 to 100,000 mPa.s. Although conventionally known materials can be used as the curable silicone composition, a curable silicone composition should be selected so that a cured product obtained upon curing may have an elemental composition represented by the formula (1). Such selection can be made with ease by those skilled in the art. Specific examples of the curable silicone composition include addition-curable, photocurable, and condensation-curable silicone compositions.

Examples of addition-curable silicone compositions include silicone compositions in which a straight-chain organopolysiloxane having alkenyl groups such as vinyl groups at the molecular chain terminals (either at one terminal or both terminals) and/or at non-terminal positions within the molecular chain, and an organohydrogenpolysiloxane are reacted (via a hydrosilylation reaction) in the presence of a platinum group metal-based catalyst to effect the curing process. Examples of photocurable silicone compositions include ultraviolet light-curable silicone compositions and electron beam-curable silicone compositions. Examples of ultraviolet light-curable silicone compositions include silicone compositions that undergo curing as a result of the energy of ultraviolet light having a wavelength within a range from 200 to 400 nm. In this case, there are no particular restrictions on the cured structure. Specific examples of suitable compositions include acrylic silicone-based silicone compositions comprising an organopolysiloxane containing acryloyl groups or methacryloyl groups, and a photopolymerization initiator, mercapto-vinyl addition polymerization-based silicone compositions comprising a mercapto group-containing organopolysiloxane, an organopolysiloxane that contains alkenyl groups such as vinyl groups, and a photopolymerization initiator, addition reaction-based silicone compositions that use the same platinum group metal-based catalysts as heat curable, addition reaction-type compositions, and cationic polymerization-based silicone compositions comprising an organopolysiloxane containing epoxy groups, and an onium salt catalyst, and any of these compositions can be used as an ultraviolet light-curable silicone composition. Examples of electron beam-curable silicone compositions that can be used include any of the silicone compositions that are cured by a radical polymerization that is initiated by irradiating an organopolysiloxane containing radical polymerizable groups with an electron beam. Examples of condensation-curable silicone compositions include silicone compositions that are cured by conducting a reaction between an organopolysiloxane with both terminals blocked with silanol groups, and an organohydrogenpolysiloxane or a hydrolyzable silane such as a tetraalkoxysilane or an organotrialkoxysilane and/or a partial hydrolysis-condensation product thereof, in the presence of a condensation reaction catalyst such as an organotin-based catalyst, or silicone compositions that are cured by reacting an organopolysiloxane with both terminals blocked with alkoxy group-containing siloxy groups or alkoxy group-containing siloxyalkyl groups, such as trialkoxysiloxy groups, dialkoxyorganosiloxy groups, trialkoxysiloxyethyl groups or dialkoxyorganosiloxyethyl groups, in the presence of a condensation reaction catalyst such as an organotin-based catalyst. However, in order to obtain the silicone fiber (2) used in the production of the silicone nonwoven fabric (2) with favorable dimensional precision, an addition-curable composition with minimal volume shrinkage is preferred.

As follows is a detailed description of representative examples of the curable silicone compositions described above, with the focus of the description on those components other than the inorganic filler, although any of the compositions may also include, if required, an inorganic filler or any other well known or conventional additives.

### <Addition-curable Silicone Compositions>

Specific examples of suitable addition-curable silicone compositions include addition-curable silicone compositions comprising:
(a) an organopolysiloxane containing at least two alkenyl groups bonded to silicon atoms,
(b) an organohydrogenpolysiloxane containing at least two hydrogen atoms bonded to silicon atoms (namely, SiH groups), in sufficient quantity that the quantity of hydrogen atoms bonded to silicon atoms within this component (b) relative to each 1 mol of alkenyl groups within the entire curable silicone composition is within a range from 0.1 to 5.0 mols, and
(c) an effective quantity of a platinum group metal-based catalyst.

### - Component (a)

The organopolysiloxane of the component (a) is the base polymer of the addition-curable silicone composition, and contains at least two alkenyl groups bonded to silicon atoms- Conventional organopolysiloxanes can be used as the component (a). The weight average molecular weight of the organopolysiloxane of the component (a), measured by gel permeation chromatography and referenced against polystyrene standards, is preferably within a range from approximately 3,000 to 300,000. Moreover, the viscosity at room temperature (25°C) of the organopolysiloxane of the component (a) is preferably within a range from 100 to 1,000,000 mPa·s, and is even more preferably from 200 to 100,000 mPa·s. The organopolysiloxane (a) is basically either a straight-chain structure with no branching, in which the molecular chain (the principal chain) comprises repeating diorganosiloxane units ((R⁴)₂SiO_{2/2} units), and both molecular chain terminals are blocked with triorganosiloxy groups ((R⁴)₃SiO_{1/2} units), or a cyclic structure with no branching in which the molecular chain comprises repeating diorganosiloxane units, although the structure may also include partial branch structures comprising R⁴SiO_{3/2} units and/or SiO_{4/2} units (here, R⁴ represents identical or different, unsubstituted or substituted monovalent hydrocarbon groups that preferably contain from 1 to 10 carbon atoms, and even more preferably from 1 to 8 carbon atoms).

Examples of the component (a) include organopolysiloxanes containing at least two alkenyl groups within each molecule, represented by an average composition formula (3) shown below.

R⁴ⱼSiO_{(4-j)/2} (3)

(wherein, R⁴ is as defined above, and j represents a positive number within a range from 1.5 to 2,8, preferably from 1,8 to 2.5, and even more preferably from 1.95 to 2.05).

Examples of the monovalent hydrocarbon groups represented by R⁴ include alkyl groups such as a methyl group, ethyl group, propyl group, isopropyl group, butyl group, isobutyl group, tert-butyl group, pentyl group, neopentyl group, hexyl group, cyclohexyl group, octyl group, nonyl group or decyl group; aryl groups such as a phenyl group, tolyl group, xylyl group or naphthyl group; aralkyl groups such as a benzyl group, phenylethyl group or phenylpropyl group; alkenyl groups such as a vinyl group, allyl group, propenyl group, isopropenyl group, butenyl group, hexenyl group, cyclohexenyl group or octenyl group; and groups in which either a portion of, or all of, the hydrogen atoms within the above hydrocarbon groups have been substituted with a halogen atom such as a fluorine, bromine or chlorine atom, or a cyano group or the like, including a chloromethyl group, chloropropyl group, bromoethyl group, trifluoropropyl group, or cyanoethyl group.

In this case, at least two of the R⁴ groups represent alkenyl groups (which preferably contain from 2 to 8 carbon atoms, and even more preferably from 2 to 6 carbon atoms). The alkenyl group quantity relative to the total of all the organic groups bonded to silicon atoms (that is, the proportion of alkenyl groups amongst all the unsubstituted and substituted monovalent hydrocarbon groups represented by R⁴ within the above average composition formula (3)) is typically within a range from 0.01 to 20 mol%, and is preferably from 0.1 to 10 mol%. In those cases where the organopolysiloxane of the component (a) has a straight-chain structure, these alkenyl groups may be bonded solely to silicon atoms at the molecular chain terminals, solely to non-terminal silicon atoms within the molecular chain, or to both these types of silicon atoms, although from the viewpoints of the composition curing rate and the physical properties of the resulting cured product, at least one alkenyl group is preferably bonded to a silicon atom at a molecular chain terminal.

The aforementioned R⁴ groups may essentially be any of the above groups, although the alkenyl groups are preferably vinyl groups, and the monovalent hydrocarbon groups other than the alkenyl groups are preferably methyl groups or phenyl groups.

Specific examples of the component (a) include compounds represented by the general formulas shown below.

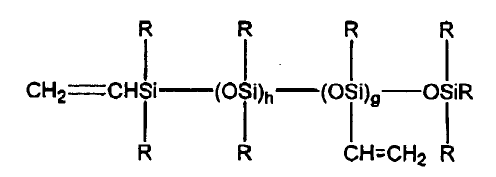

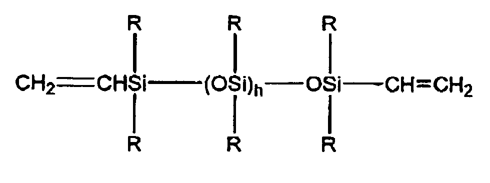

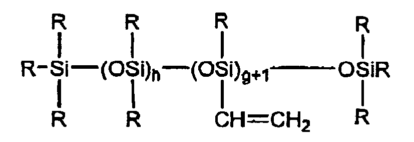

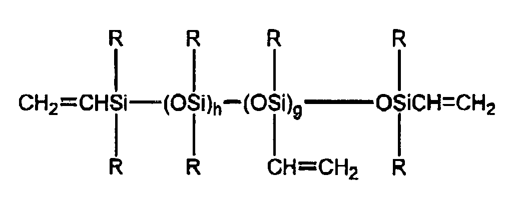

In the above general formulas, R has the same meaning as R⁴ with the exception of not including alkenyl groups. g and h are integers that satisfy g ≥ 1 and h ≥ 0 respectively, and the value of g+h is a number that enables the molecular weight and viscosity of the organopolysiloxane to satisfy the values described above.

### - Component (b)

The organohydrogenpolysiloxane of the component (b) contains at least two (typically from 2 to 200), and preferably three or more (typically from 3 to 100) hydrogen atoms bonded to silicon atoms (SiH groups). The component (b) reacts with the component (b) and functions as a cross-linking agent, There are no particular restrictions on the molecular structure of the organohydrogenpolysiloxane, and conventionally produced linear, cyclic, branched, or three dimensional network (resin-like) organohydrogenpolysiloxanes can be used as the component (b). In those cases where the component (a) has a linear structure, the SiH groups may be bonded solely to silicon atoms at the molecular chain terminals, or solely to non-terminal silicon atoms within the molecular chain, or may also be bonded to both these types of silicon atoms. Furthermore, the number of silicon atoms within each molecule (namely, the polymerization degree) is typically within a range from 2 to 300, and is preferably from 4 to 150, and an organohydrogenpolysiloxane that is liquid at room temperature (25°C) is particularly favorable as the component (b).

Examples of the component (b) include organohydrogenpolysiloxanes represented by an average composition formula (4) shown below.

R⁵_{d}HₑSiO_{(4-d-e)/2} (4)

(wherein, R⁵ represents identical or different, unsubstituted or substituted monovalent hydrocarbon groups of 1 to 10 carbon atoms, d and e represent positive numbers that preferably satisfy 0.7 ≤ d ≤2.1, 0.001 ≤ e ≤ 1.0 and 0.8 ≤ d+e ≤ 3.0, and even more preferably satisfy 1.0 ≤ d ≤2.0, 0.01 ≤ e ≤ 1.0 and 1.5 ≤ d+e ≤ 2.5)

Examples of the group R⁵ include the same groups as those described above for the group R⁴ within the above average composition formula (3) (but excluding the alkenyl groups).

Specific examples of organohydrogenpolysiloxanes represented by the above average composition formula (4) include 1,1,3,3-tetramethyldisiloxane, 1,3,5,7-tetramethylcyclotetrasiloxane, tris(hydrogendimethylsiloxy)methylsilane, tris(hydrogendimethylsiloxy)phenylsilane, methylhydrogencyclopolysiloxane, cyclic copolymers of methylhydrogensiloxane and dimethylsiloxane, methylhydrogenpolysiloxane with both terminals blocked with trimethylsiloxy groups, copolymers of dimethylsiloxane and methylhydrogensiloxane with both terminals blocked with trimethylsiloxy groups, dimethylpolysiloxane with both terminals blocked with dimethylhydrogensiloxy groups, copolymers of dimethylsiloxane and methylhydrogensiloxane with both terminals blocked with dimethylhydrogensiloxy groups, copolymers of methylhydrogensiloxane and diphenylsiloxane with both terminals blocked with trimethylsiloxy groups, copolymers of methylhydrogensiloxane, diphenylsiloxane and dimethylsiloxane with both terminals blocked with trimethylsiloxy groups, copolymers of methylhydrogensiloxane, methylphenylsiloxane and dimethylsiloxane with both terminals blocked with trimethylsiloxy groups, copolymers of methylhydrogensiloxane, dimethylsiloxane and diphenylsiloxane with both terminals blocked with dimethylhydrogensiloxy groups, copolymers of methylhydrogensiloxane, dimethylsiloxane and methylphenylsiloxane with both terminals blocked with dimethylhydrogensiloxy groups, copolymers composed of (CH₃)₂HSiO_{1/2} units, (CH₃)₃SiO_{1/2} units, and SiO_{4/2} units, copolymers composed of (CH₃)₂HSiO_{1/2} units and SiO_{4/2} units, and copolymers composed of (CH₃)₂HSiO_{1/2} units, SiO_{4/2} units, and (C₆H₅)₃SiO_{1/2} units.

The quantity added of the component (b) must be sufficient that the quantity of SiH groups within this component (b), relative to each I mol of alkenyl groups bonded to silicon atoms within the component (a), is within a range from 0,1 to 5,0 mols, preferably from 0.5 to 3.0 mols, and even more preferably from 0.8 to 2.0 mols. If the quantity added of the component (b) yields a quantity of SiH groups that is less than 0.1 mols, then the cross-linking density of the cured product obtained from the composition is too low, which has an adverse effect on the heat resistance of the cured product. In contrast, if the quantity added yields a quantity of SiH groups that exceeds 5.0 mols, then foaming problems caused by a dehydrogenation reaction may occur within the cured product, and the heat resistance of the resulting cured product may also deteriorate.

### - Component (c)

The platinum group metal-based catalyst of the component (c) is used for accelerating the addition curing reaction (the hydrosilylation) between the component (a) and the component (b). Conventional platinum group metal-based catalysts can be used as the component (c), although the use of platinum or a platinum compound is preferred. Specific examples of the component (c) include platinum black, platinic chloride, chloroplatinic acid, alcohol-modified chloroplatinic acid, and coordination compounds of chloroplatinic acid with olefins, aldehydes, vinylsiloxanes or acetylene alcohols.

The quantity added of the component (c) need only be an effective catalytic quantity, may be suitable increased or decreased in accordance with the desired curing rate, and preferably yields a mass of the platinum group metal relative to the mass of the component (a) that falls within a range from 0.1 to 1,000 ppm, and even more preferably from 1 to 200 ppm.

### < Ultraviolet Light-curable Silicone Compositions>

Specific examples of suitable ultraviolet light-curable silicone compositions include ultraviolet light-curable silicone compositions comprising:
(d) an ultraviolet light-reactive organopolysiloxane, and
(e) a photopolymerization initiator.

### - Component (d)

The ultraviolet light-reactive organopolysiloxane of the component (d) typically functions as the base polymer of the ultraviolet light-curable silicone composition. Although there are no particular restrictions on the component (d), the component (d) is preferably an organopolysiloxane containing at least two, even more preferably from 2 to 20, and most preferably from 2 to 10, ultraviolet light-reactive groups within each molecule. The plurality of ultraviolet light-reactive groups that exist within this organopolysiloxane may be the same, or different.

The organopolysiloxane of the component (d) is preferably basically either a straight-chain structure with no branching, in which the molecular chain comprises repeating diorganosiloxane units, and both molecular chain terminals are blocked with triorganosiloxy groups or triorganosilyl-substituted alkyl groups such as triorganosilylethyl groups, or a cyclic structure with no branching in which the molecular chain comprises repeating diorganosiloxane units, although the structure may also include partial branched structures such as trifunctional siloxane units and SiO₂ units. In those cases where the organopolysiloxane of the component (d) has a straight-chain structure, the ultraviolet light-reactive groups may exist solely at the molecular chain terminals, solely at non-terminal positions within the molecular chain, or may also exist at both these positions, although structures containing ultraviolet light-reactive groups at least at the molecular chain terminals are preferred.

The ultraviolet light-reactive groups may be directly bonded to silicon atoms constituting the backbone chain of the organopolysiloxane of the component (d) or bonded to silicon atoms via linkage groups such as alkylene groups, depending on the types of the ultraviolet light-reactive groups.

Examples of ultraviolet light-reactive groups include alkenyl groups such as a vinyl group, allyl group or propenyl group; alkenyloxy groups such as a vinyloxy group, allyloxy group, propenyloxy group or isopropenyloxy group; aliphatic unsaturated groups other than alkenyl groups, such as an acryloyl group or methacryloyl group; as well as a mercapto group, epoxy group, or hydrosilyl group, and of these, an acryloyl group, methacryloyl group, mercapto group, epoxy group or hydrosilyl group is preferred, and an acryloyl group or methacryloyl group is particularly desirable.

Although there are no particular restrictions on the viscosity of the organopolysiloxane, the viscosity at 25°C is preferably at least 25 mPa·s, and is even more preferably within a range from 100 to 10,000,000 mPa·s, and most preferably from 100 to 100,000 mPa·s.

Examples of preferred forms of the component (d) include organopolysiloxanes containing at least two ultraviolet light-reactive groups, represented by either a general formula (5) shown below: 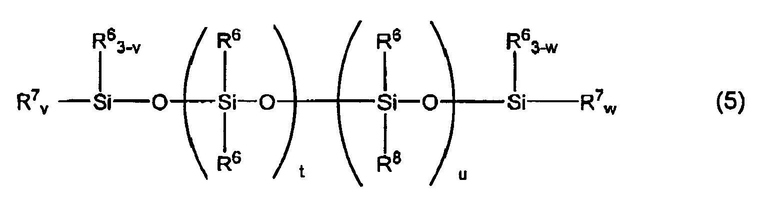 [wherein, R⁶ represents identical or different, unsubstituted or substituted monovalent hydrocarbon groups that contain no ultraviolet light-reactive groups, R⁷ and R⁸ each represent identical or different ultraviolet light-reactive groups or groups that contain an ultraviolet light-reactive group, t represents an integer from 5 to 1,000, u represents an integer from 0 to 100, v represents an integer from 0 to 3, and w represents an integer from 0 to 3, provided that v+w+u ≥ 2]
or a general formula (6) shown below: 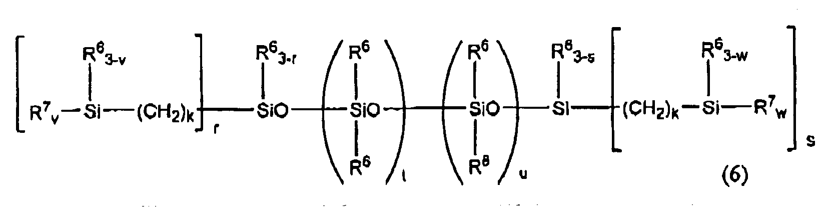 [wherein, R⁶, R⁷, R⁸, t, u, v and w are as defined above for the general formula (5), k represents an integer from 2 to 4, and r and s each represent an integer from 1 to 3, provided that vr+ws+u ≥ 2].

In the above general formulas (5) and (6), R⁶ represents identical or different, unsubstituted or substituted monovalent hydrocarbon groups that contain no ultraviolet light-reactive groups, and preferably contain from 1 to 20, even more preferably from 1 to 10, and most preferably from 1 to 8 carbon atoms. Examples of the monovalent hydrocarbon groups represented by R⁶ include alkyl groups such as a methyl group, ethyl group, propyl group, butyl group, isopropyl group, isobutyl group, tert-butyl group, hexyl group, 2-ethylhexyl group, 2-ethylbutyl group, or octyl group; cycloalkyl groups such as a cyclohexyl group or cyclopentyl group; aryl groups such as a phenyl group, tolyl group, xylyl group, naphthyl group, or diphenyl group; aralkyl groups such as a benzyl group or phenylethyl group; and groups in which a portion of, or all of, the hydrogen atoms bonded to carbon atoms within the above hydrocarbon groups have been substituted with a halogen atom, cyano group, amino group, or carboxyl group or the like, including a chloromethyl group, trifluoropropyl group, 2-cyanoethyl group, and 3-aminopropyl group, and of these, a methyl group or phenyl group is preferred, and a methyl group is particularly desirable. Furthermore, the monovalent hydrocarbon group represented by R⁶ may also include one or more sulfonyl groups, ether linkages (-O-) or carbonyl groups or the like within the group skeleton,

In the above general formulas (5) and (6), examples of the ultraviolet light-reactive groups represented by R⁷ and R⁸ are as described above. The groups containing an ultraviolet light-reactive group mean groups which are formed of an ultraviolet light-reactive group and at least one linkage group to which the ultraviolet light-reactive group is bonded, and are bonded to silicon atoms at the linkage group, and specific examples thereof include a 3-glycidoxypropyl group, 2-(3,4-epoxycyclohexyl)ethyl group, 3-methacryloyloxypropyl group, 3-acryloyloxypropyl group, 3-mercaptopropyl group, 2-{bis(2-methacryloyloxyethoxy)methylsilyl}ethyl group, 2-{(2-methacryloyloxyethoxy)dimethylsilyl}ethyl group, 2-{bis(2-acryloyloxyethoxy)methylsilyl}ethyl group, 2-{(2-acryloyloxyethoxy)dimethylsilyl}ethyl group, 2-{bis(1,3-dimethacryloyloxy-2-propoxy)methylsilyl}ethyl group, 2-{(1,3-dimethacryloyloxy-2-propoxy)dimethylsilyl}ethyl group, 2-{bis(1-acryloyloxy-3-methacryloyloxy-2-propoxy)methylsilyl}ethyl group, and 2-{(1-acryloyloxy-3-methacryloyloxy-2-propoxy)dimethylsilyl}ethyl group, examples of preferred groups include a 3-methacryloyloxypropyl group, 3-acryloyloxypropyl group, 2-{bis(2-methacryloyloxyethoxy)methylsilyl}ethyl group, 2-{(2-methacryloyloxyethoxy)dimethylsilyl}ethyl group, 2-{bis(2-acryloyloxyethoxy)methylsilyl}ethyl group, 2-{(2-acryloyloxyethoxy)dimethylsilyl}ethyl group, 2-{bis(1,3-dimethacryloyloxy-2-propoxy)methylsilyl}ethyl group, 2-{(1,3-dimetbacryloyloxy-2-propoxy)dimethylsilyl} ethyl group, 2-{bis(1-acryloyloxy-3-methacryloyloxy-2-propoxy)methylsilyl}ethyl group, and 2-{(1-acryloyloxy-3-methacryloyloxy-2-propoxy)dimethylsilyl}ethyl group, and examples of more preferred groups include a 3-acryloyloxypropyl group, 2-{bis(2-methacryloyloxyethoxy)methylsilyl}ethyl group, 2-{(2-methacryloyloxyethoxy)dimethylsilyl}ethyl group, 2-{(2-acryloyloxyethoxy)dimethylsilyl} ethyl group, 2-{bis(1,3-dimethacryloyloxy-2-propoxy)methylsilyl}ethyl group, and 2-{bis(1-acryloyloxy-3-methacryloyloxy-2-propoxy)methylsilyl}ethyl group.

In general formulas (5) and (6), R⁷ and R⁸ may be either the same or different, and individual R⁷ and R⁸ groups may be the same as, or different from, other R⁷ and R⁸ groups.

In the above general formulas (5) and (6), t is typically an integer within a range from 5 to 1,000, and is preferably an integer from 10 to 800, and even more preferably from 50 to 500. u is typically an integer within a range from 0 to 100, and is preferably an integer from 0 to 50, and even more preferably from 0 to 20. v is typically an integer within a range from 0 to 3, and is preferably an integer from 0 to 2, and even more preferably either 1 or 2. w is preferably an integer from 0 to 2, and is even more preferably either 1 or 2. In the above general formula (6), k is typically an integer within a range from 2 to 4, and is preferably either 2 or 3. r and s each represent an integer from 1 to 3, and preferably represent either 1 or 2. Moreover, as described above, the organopolysiloxanes represented by the above general formulas (5) and (6) contain at least two of the above ultraviolet light-reactive groups, and consequently v+w+u ≥ 2 in the formula (5), and Vr+ws+u ≥ 2 in the formula (6).

Specific examples of organopolysiloxanes represented by the above formulas (5) or (6) include the compounds shown below. 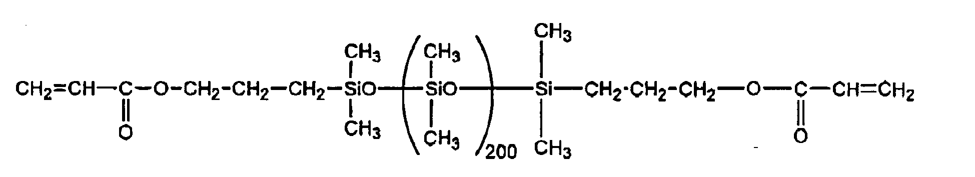 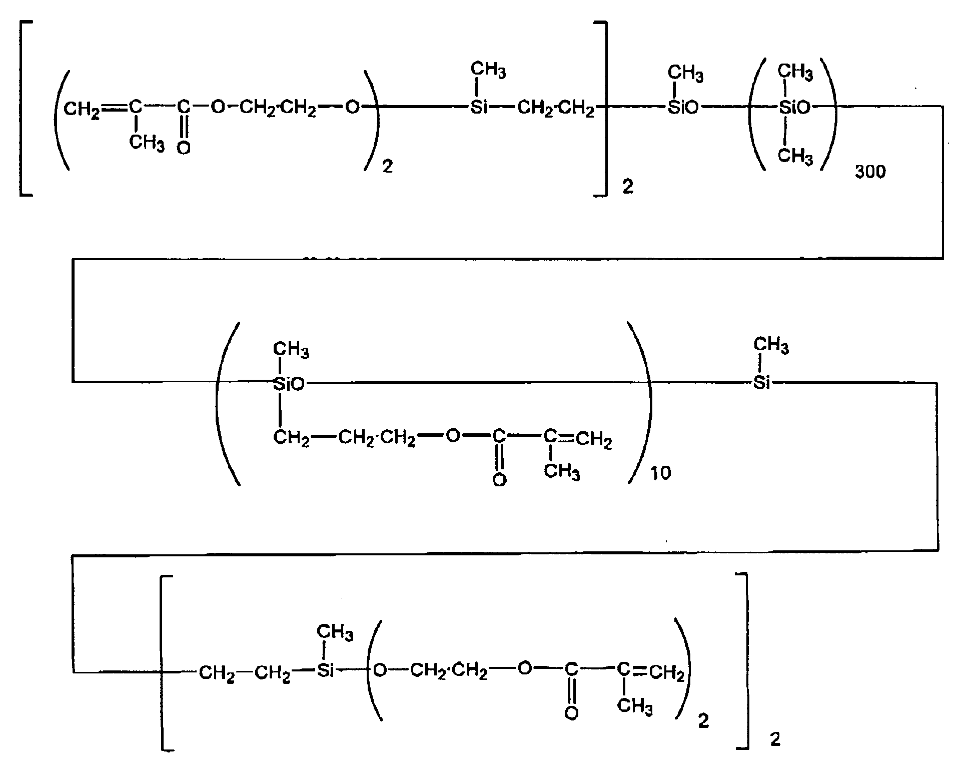 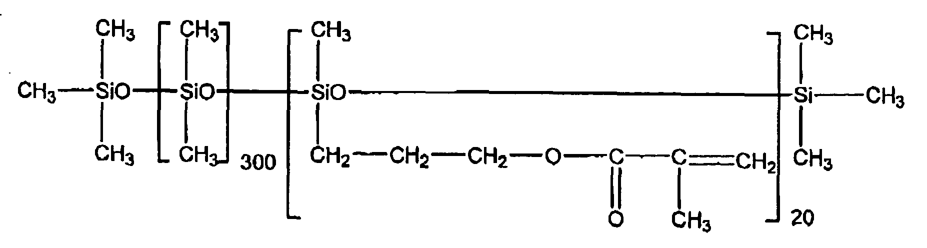 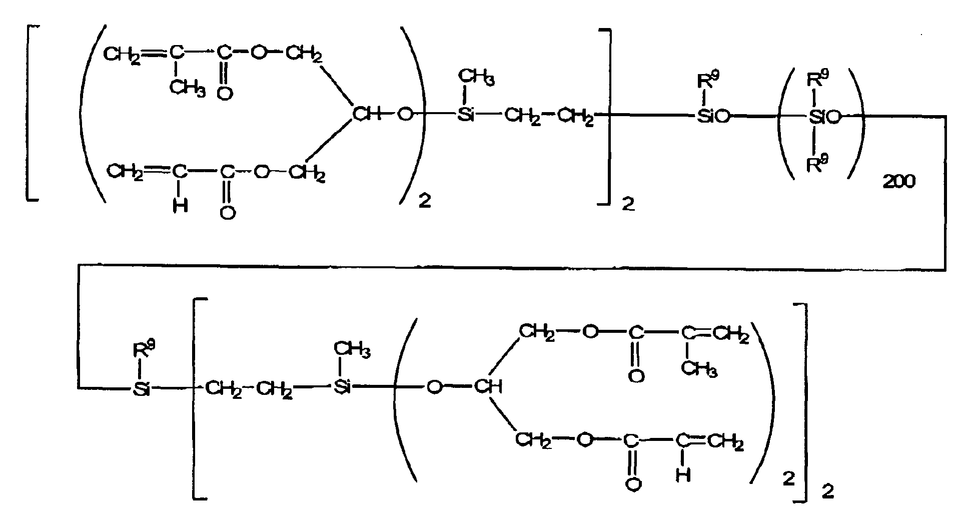 [wherein, 90 mol% of the R⁹ groups are methyl groups and 10 mol% thereof are phenyl groups]

### -Component (e)

The photopolymerization initiator of the component (e) has the effect of accelerating the photopolymerization of the ultraviolet light-reactive groups within the above component (d). There are no particular restrictions on the component (e), and specific examples of suitable initiators include acetophenone, propiophenone, benzophenone, xanthol, fluorein, benzaldehyde, anthraquinone, triphenylamine, 4-methylacetophenone, 3-pentylacetopbenone, 4-methoxyacetophenone, 3-bromoacetophenone, 4-allylacetophenone, p-diacetylbenzene, 3-methoxybenzophenone, -4-methylbenzophenone,-4-chlorobenzophenone,4,4'-dimethoxybenzophenone, 4-chloro-4'-benzylbenzophenone, 3-chloroxanthone, 3,9-dichloroxanthone, 3-chloro-8-nonylxanthone, benzoin, benzoin methyl ether, benzoin butyl ether, bis(4-dimethylaminophenyl) ketone, benzyl methoxy acetal, 2-chlorothioxanthone, diethylacetophenone, 1-hydroxycyclohexyl phenyl ketone, 2-methyl-(4-(methylthio)phenyl)-2-morpholino-1-propane, 2,2-dimethoxy2-phenylacetophenone, diethoxyacetophenone, and 2-hydroxy-2-methyl-1-phenylpropan-1-one, preferred initiators include benzophenone, 4-methoxyacetophenone, 4-methylbenzophenone, diethoxyacetophenone, 1-hydroxycyclohexyl phenyl ketone, and 2-hydroxy-2-methyl-1-phenylpropan-1-one, and particularly desirable initiators include diethoxyacetophenone, 1-hydroxycyclohexyl phenyl ketone, and 2-hydroxy-2-methyl-1-phenylpropan-1-one. These photopolymerization initiators may be used either alone, or in combinations of two or more different initiators.

Although there are no particular restrictions on the quantity added of the component (e), the quantity is preferably within a range from 0.01 to 10 parts by mass, even more preferably from 0.1 to 3 parts by mass, and most preferably from 0,5 to 3 parts by mass, per 100 parts by mass of the component (d). Provided the quantity added falls within the above range, the cured product obtained upon curing the composition of the present invention exhibits excellent physical properties such as strength and tensile strength.

### < Condensation-curable Silicone Compositions>

Specific examples of suitable condensation-curable silicone compositions include a condensation-curable silicone composition comprising:
(h) an organopolysiloxane containing at least two silicon atom-bonded hydroxyl groups or silicon atom-bonded hydrolyzable groups, preferably at both molecular chain terminals,
(i) a hydrolyzable silane and/or a partial hydrolysis-condensation product thereof as an optional component, and
(j) a condensation reaction catalyst as another optional component.

### - Component (h)

The component (h) is an organopolysiloxane that contains at least two silicon atom-bonded hydroxyl groups or silicon atom-bonded hydrolyzable groups, and functions as the base polymer of the condensation-curable silicone composition. The organopolysiloxane of the component (h) is basically a straight-chain structure or cyclic structure with no branching, in which the molecular chain comprises repeating diorganosiloxane units, although the structure may also include partial branch structures.

Incidentally, in the present specification, the "hydrolyzable group" refers to a group which can form a hydroxy group upon decomposition by the action of water.

In the organopolysiloxane of the component (h), examples of suitable hydrolyzable groups include acyloxy groups such as an acetoxy group, octanoyloxy group, or benzoyloxy group; ketoxime groups (namely, iminoxy groups) such as a dimethyl ketoxime group, methyl ethyl ketoxime group, or diethyl ketoxime group; alkoxy groups such as a methoxy group, ethoxy group, or propoxy group; alkoxyalkoxy groups such as a methoxyethoxy group, ethoxyethoxy group, or methoxypropoxy group; alkenyloxy groups such as a vinyloxy group, isopropenyloxy group, or 1-ethyl-2-methylvinyloxy group; amino groups such as a dimethylamino group, diethylamino group, butylamino group, or cyclohexylamino group; aminoxy groups such as a dimethylaminoxy group or diethylaminoxy group; and amide groups such as an N-methylacetamide group, N-ethylacetamide group, or N-methylbenzamide group.

These hydrolyzable groups are preferably positioned at both molecular chain terminals of a straight-chain diorganopolysiloxane, preferably in the form of either siloxy groups that contain two or three hydrolyzable groups, or siloxyalkyl groups that contain two or three hydrolyzable groups, including trialkoxysiloxy groups, dialkoxyorganosiloxy groups, triacyloxysiloxy groups, diacyloxyorganosiloxy groups, triiminoxysiloxy groups (namely, triketoximesiloxy groups), diiminoxyorganosiloxy groups, trialkenoxysiloxy groups, dialkenoxyorganosiloxy groups, trialkoxysiloxyethyl groups, and dialkoxyorganosiloxyethyl groups.

The other atoms or groups bonded to silicon atoms, besides the above hydroxyl groups and hydrolyzable groups, are monovalent hydrocarbon groups, and examples of these monovalent hydrocarbon groups include the same unsubstituted or substituted monovalent hydrocarbon groups as those exemplified above in relation to R⁴ within the above average composition formula (3).

Suitable examples of the component (h) include the organopolysiloxanes with both molecular chain terminals with silicon atom-bonded hydroxyl groups or silicon atom-bonded hydrolyzable groups represented by the formulas shown below. 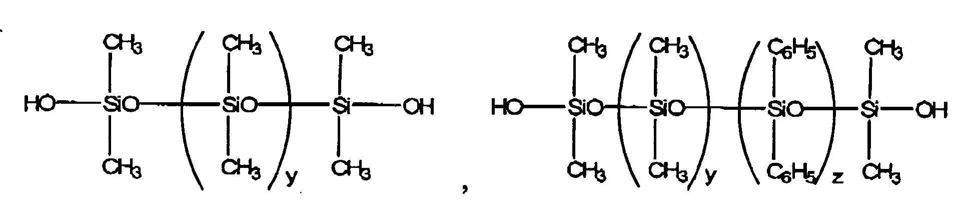 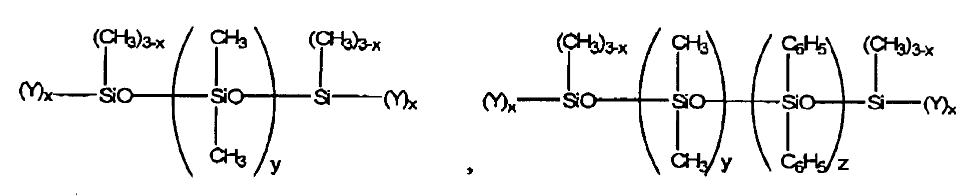 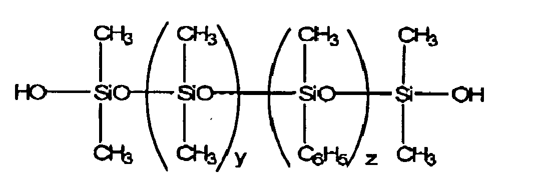 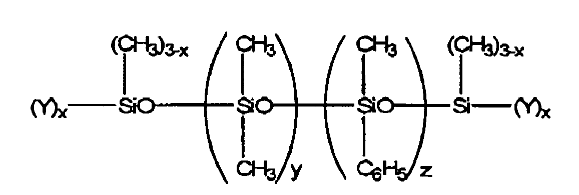 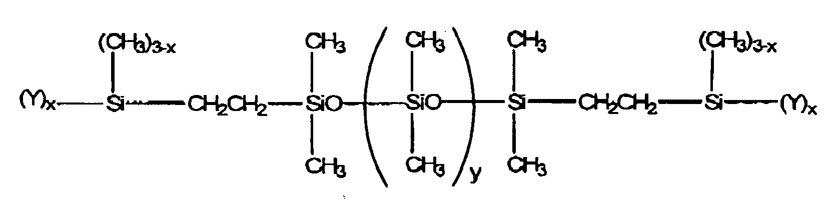 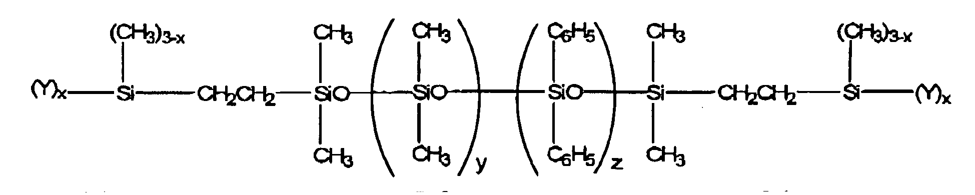 [wherein, Y represents a hydrolyzable group, x represents 1, 2, or 3, and y and z each represent an integer of 1 to 1,000]

Of the organopolysiloxanes represented by the above chemical formulas, specific examples of compounds containing hydrolyzable groups Y at both terminals include dimethylpolysiloxane with both molecular chain terminals blocked with trimethoxysiloxy groups, copolymers of dimethylsiloxane and methylphenylsiloxane with both molecular chain terminals blocked with trimethoxysiloxy groups, copolymers of dimethylsiloxane and diphenylsiloxane with both molecular chain terminals blocked with trimethoxysiloxy groups, dimethylpolysiloxane with both molecular chain terminals blocked with methyldimethoxysiloxy groups, dimethylpolysiloxane with both molecular chain terminals blocked with triethoxysiloxy groups, and dimethylpolysiloxane with both molecular chain terminals blocked with 2-(trimethoxysiloxy)ethyl groups. These compounds may be used either alone, or in combinations of two or more different compounds,

### -Component (i)

The hydrolyzable silane and/or partial hydrolysis-condensation product thereof of the component (i) is an optional component, and functions as a curing agent. In those cases where the base polymer of the component (h) is an organopolysiloxane that contains at least two silicon atom-bonded hydrolyzable groups other than silanol groups within each molecule, the addition of the component (i) to the condensation-curable silicone composition can be omitted. Silanes containing at least three silicon atom-bonded hydrolyzable groups within each molecule and/or partial hydrolysis-condensation products thereof (namely, organopolysiloxanes that still retain at least one, and preferably two or more of the hydrolyzable groups) can be used particularly favorably as the component (i).

Examples of preferred forms of the above hydrolyzable silane include compounds represented by a formula (7) shown below:

R¹⁰_{f}SIX_{4-f} (7)

(wherein, R¹⁰ represents an unsubstituted or substituted monovalent hydrocarbon group, X represents a hydrolyzable group, and f represents either 0 or 1). Examples of R¹⁰ include alkyl groups such as a methyl group or ethyl group; alkenyl groups such as a vinyl group, allyl group or propenyl group; and aryl groups such as a phenyl group. Examples of X include all of the groups exemplified as potential silicon atom-bonded hydrolyzable groups Y within the aforementioned component (h).

Specific examples of the hydrolyzable silane include methyltriethoxysilane, vinyltriethoxysilane, vinyltriacetoxysilane, ethyl orthosilicate, and partial hydrolysis-condensation products of these compounds. These compounds may be used either alone, or in combinations of two or more different compounds.

In those cases where a hydrolyzable silane and/or partial hydrolysis-condensation product thereof of the component (i) is used, the quantity added is preferably within a range from 0.01 to 20 parts by mass, and even more preferably from 0.1 to 10 parts by mass, per 100 parts by mass of the component (h). In those cases where a component (i) is used, using a quantity within the above range ensures that the composition of the present invention exhibits particularly superior levels of storage stability and adhesiveness, as well as a favorable curing rate.

### - Component (j)

The condensation reaction catalyst of the component (j) is an optional component, and is unnecessary in cases where the above hydrolyzable silane and/or partial hydrolysis-condensation product thereof of the component (i) contains aminoxy groups, amino groups, or ketoxime groups or the like. Examples of the condensation reaction catalyst of the component (j) include organotitanate esters such as tetrabutyl titanate and tetraisopropyl titanate; organotitanium chelate compounds such as diisopropoxybis(acetylacetonato)titanium and diisopropoxybis(ethylacetoacetate)titanium; organoaluminum compounds such as aluminum tris(acetylacetonate) and aluminum tris(ethylacetoacetate); organozirconium compounds such as zirconium tetra(acetylacetonate) and zirconium tetrabutyrate; organotin compounds such as dibutyltin dioctoate, dibutyltin dilaurate and dibutyltin (2-ethylhexanoate); metal salts of organic carboxylic acids such as tin naphthenate, tin oleate, tin butyrate, cobalt naphthenate, and zinc stearate; amine compounds or the salts thereof such as hexylamine and dodecylamine phosphate; quaternary ammonium salts such as benzyltriethylammonium acetate; lower fatty acid salts of alkali metals such as potassium acetate; dialkylhydroxylamines such as dimethylhydroxylamine and diethylhydroxylamine; and guanidyl group-containing organosilicon compounds. These catalysts may be used either alone, or in combinations of two or more different catalysts.

In those cases where a condensation reaction catalyst of the component (j) is used, although there are no particular restrictions on the quantity added, the quantity is preferably within a range from 0.01 to 20 parts by mass, and even more preferably from 0.1 to 10 parts by mass, per 100 parts by mass of the component (h). If the component (j) is used, then provided the quantity falls within the above range, the composition of the present invention exhibits superior levels of curability and storage stability.

### - Method of Producing Silicone Fiber (2)

The silicone fiber (2) can be produced by a process comprising continuously extruding a curable silicone composition which is liquid at room temperature through an aperture to form a fiber of the curable silicone composition, drawing out the fiber of the curable silicone composition, and curing the fiber of the curable silicone composition while the fiber is drawn out.

This silicone fiber (2) can be used favorably in the production of the silicone nonwoven fabric (2). The fiber diameter of the silicone fiber (2) is preferably within a range from 0.1 to 50 µm, and is even more preferably from 0.5 to 30 µm. Provided the fiber diameter is within this range, the curing rate of the curable silicone composition is satisfactorily fast, the fiber shape can be more readily maintained, and production of the fiber is simplified. Furthermore, aggregation of the product fiber is unlikely, which facilitates production of a nonwoven fabric.

Examples of the above aperture from which the curable silicone composition is extruded in this method include the nozzle aperture of the fiber spinning nozzle described above. The internal diameter of the aperture can be selected in accordance with factors such as the desired fiber diameter and the extrusion speed of the curable silicone composition, and is typically within a range from 100 µm to 1 mm. Suitable shapes for the aperture include a circle or an ellipse or the like. The number of apertures may be either one or a plurality. In the case of a plurality of apertures, suitable positional arrangements for the apertures include linear, circular, concentric circular, radial, or lattice-like arrangements. Furthermore, in the case of a plurality of apertures, the spacing between apertures is typically within a range from 0.01 to 50 mm, and is preferably from 0.1 to 10 mm.

The extrusion speed of the curable silicone composition is typically within a range from approximately 100 to 10,000 m/minute. Faster extrusion speeds enable the production of fibers with smaller fiber diameters. There are no particular restrictions on the temperature during the continuous extrusion of the curable silicone composition from the aperture, provided the curable silicone composition is maintained in liquid form, and this temperature may be selected appropriately in accordance with the nature of the curable silicone composition. One example of a suitable temperature is room temperature. During production of a silicone fiber using this method, examples of suitable production atmospheres include air, or an inert gas such as argon gas or nitrogen gas.

A receiver is usually positioned below the above aperture, so as to collect the silicone fiber obtained using the above method. There are no particular restrictions on the shape, material, or structure of the receiver, which may be the same as those described for the production of the silicone nonwoven fabric (1). There are no particular restrictions on the height from the aperture to the receiver, provided the curable silicone composition is able to cure while the fiber is drawn out, and this height may be selected appropriately in accordance with factors such as the nature of the silicone composition, and the extrusion speed and curing rate of the composition.

As follows is a description of preferred curing conditions for representative curable silicone compositions.

### (The case of an Addition-curable Silicone Composition)

Using a heating device to heat the addition-curable silicone composition during the drawing of the fiber causes the hydrosilylation reaction to proceed within the silicone composition, thereby curing the silicone composition and yielding a silicone fiber. The heating device is usually positioned close to the path of the silicone composition being drawn, so that the silicone composition can be heated to a predetermined temperature, Examples of suitable heating devices include heaters and the like. The heating temperature can be selected appropriately in accordance with the fiber diameter, namely the diameter of the aforementioned aperture, and the extrusion speed of the addition-curable silicone composition, and is preferably within a range from 80 to 300°C, and even more preferably from 100 to 200°C. Furthermore, secondary curing may also be conducted if required, and the temperature conditions during such secondary curing are preferably at least 120°C, and even more preferably within a range from 150 to 250°C. The secondary curing time is preferably within a range from 10 minutes to 48 hours, and even more preferably from 30 minutes to 24 hours.

### (The case of an Ultraviolet Light-curable Silicone Composition)

By irradiating the ultraviolet light-curable silicone composition with ultraviolet light during the drawing of the fiber, a curing reaction is initiated within the silicone composition by the photopolymerization initiator, thereby curing the silicone composition and forming a silicone fiber. The ultraviolet light irradiation device is positioned so as to be able to irradiate the silicone composition with ultraviolet light during the drawing of the fiber. Examples of suitable ultraviolet light irradiation devices include ultraviolet lamps and ultraviolet light emitting diodes. The ultraviolet light irradiation conditions can be selected appropriately in accordance with the fiber diameter, namely the diameter of the aforementioned aperture, and the extrusion speed of the silicone composition. For example, the ultraviolet light irradiation typically uses an ultraviolet lamp or ultraviolet light emitting diode with an emission wavelength of 365 nm, and can be conducted under conditions including an illumination intensity of 5 to 500 mW/cm², and preferably from 10 to 200 mW/cm², and an amount of light of 0,5 to 100 J/cm², and preferably from 10 to 50 J/cm². Furthermore, secondary curing may also be conducted if required, and the temperature conditions during such secondary curing are preferably at least 120°C, and even more preferably within a range from 150 to 250°C, The secondary curing time is preferably within a range from 10 minutes to 48 hours, and even more preferably from 30 minutes to 24 hours.

### (The case of a Condensation-curable Silicone Composition)

By passing the condensation-curable silicone composition through an atmosphere that contains moisture (for example, a humidity within a range from 25 to 90% RH, and preferably from 50 to 85% RH) during the drawing of the fiber, the composition can be cured, yielding a silicone fiber. Heating may be conducted in the same manner as that used for an addition-curable silicone composition in order to accelerate the curing process. Furthermore, secondary curing may also be conducted if required, and the temperature conditions during such secondary curing are preferably at least 120°C, and even more preferably within a range from 150 to 250°C. The secondary curing time is preferably within a range from 10 minutes to 48 hours, and even more preferably from 30 minutes to 24 hours.

### - Dry Method of Producing Silicone Nonwoven Fabric (2)

The silicone nonwoven fabric (2) can be produced by obtaining the silicone fiber (2) using the method described above, and then subjecting the silicone fiber (2) to suction collection on a receiver.

According to this method, a nonwoven fabric in a form of felt is obtained.

When the silicone fiber is subjected to suction collection on the receiver, the silicone fibers become effectively intertwined, yielding a silicone nonwoven fabric with excellent strength.

The suction collection described above can be conducted by airflow or static electricity or the like, but is preferably conducted by airflow, In those cases where the suction collection is conducted by airflow, a material with favorable air permeability must be selected as the material for the receiver, and the suction speed is typically within a range from 2 to 10 m/s. By generating an airflow that passes through the receiver, from the side closer to the aperture through to the opposite side, suction collection can be conducted under the effects of the airflow. Suitable materials for this type of receiver include plastics, glass, metals and rubbers. Furthermore, in those cases where the suction collection is conducted by static electricity, a chargeable material is selected as the material for the receiver, and suitable materials include metals or plastics.

### - Wet Method of Producing Silicone Nonwoven Fabric (2)

The silicone nonwoven fabric (2) can be produced by obtaining the silicone fiber (2) using the method described above, dispersing the silicone fiber (2) within an aqueous medium containing a binder to prepare a slurry, and then producing the silicone nonwoven fabric (2) from the slurry using a papermaking process.

According to this method, a nonwoven fabric is obtained as a bonded fabric.

In this method, the aqueous medium and the slurry are as described in the description of the wet production method for silicone nonwoven fabric (1), and the silicone nonwoven fabric can be produced from the slurry using a process that is essentially the same as a typical papermaking process.

In either of the above methods of producing the silicone nonwoven fabric (2), the fiber diameter of the silicone fiber (2) preferably falls within the range described above.

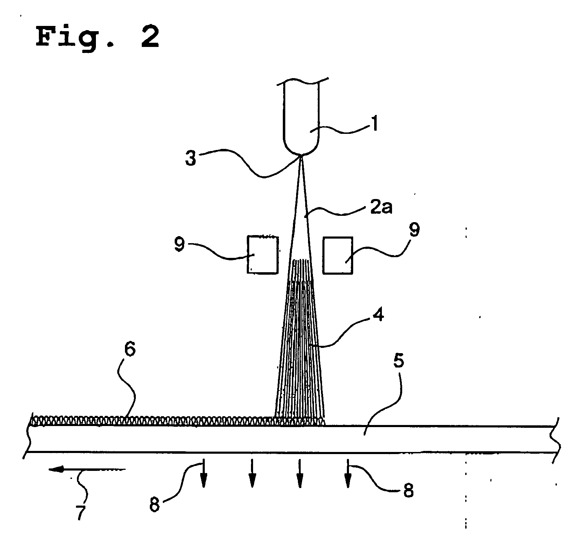

Production of the silicone nonwoven fabric (2) is described in more detail below, with reference to Fig. 2.

Fig. 2 is a schematic diagram describing a method of producing a silicone nonwoven fabric of the present invention using a dry method. A curable silicone composition 2a supplied via a fiber spinning nozzle 1 is extruded from a nozzle aperture 3 and falls vertically downward. The number of fiber spinning nozzles 1 may be either one, or a plurality. In the case of a plurality of fiber spinning nozzles 1, a multitude of positional arrangements are possible for the nozzles, although the arrangement is preferably such that a uniform quantity of the cured silicone fiber falls onto a fixed region of the receiver. For example, the tips of the nozzles may be arranged along a horizontal line, at the same height and with a uniform spacing between nozzles, or may be arranged in a two dimensional pattern within a horizontal plane, In the case of a two dimensional arrangement, the arrangement pattern may be a circle, a series of two or more concentric circles, or a radial pattern.

An apparatus 9 for curing the composition, which is selected in accordance with the nature of the composition, is positioned close to the path along which the curable silicone composition 2a falls. In those cases where the curable silicone composition 2a is an addition-curable silicone composition, the apparatus 9 is a heating apparatus, and as the curable silicone composition 2a passes close to the apparatus 9 it is heated and cured, thereby forming a cured silicone fiber 4. In those cases where the curable silicone composition 2a is an ultraviolet light-curable silicone composition, the apparatus 9 is an ultraviolet light irradiation apparatus, and as the curable silicone composition 2a passes close to the apparatus 9 it is irradiated with ultraviolet light and cured, thereby forming a cured silicone fiber 4. In those cases where the curable silicone composition 2a is a condensation-curable silicone composition, the curable silicone composition 2a is cured by moisture contained within the atmosphere, thereby forming a cured silicone fiber 4, and consequently the apparatus 9 is unnecessary, although a heating apparatus may be provided as the apparatus 9 in order to accelerate the curing process.

The formed cured silicone fiber 4 reaches the surface of a belt 5 of a belt conveyor. An arrow 7 indicates the travel direction of the belt 5. The belt 5 has a structure that exhibits air permeability, and is formed from a metal, plastic or rubber or the like. By applying suction from beneath the belt 5, an airflow is generated which passes through the belt 5 from top to bottom in the direction of an arrow 8. The cured silicone fiber 4 that reaches the surface of the belt 5 is collected on top of the belt 5 by the suction generated by the downward airflow. During this suction collection, the cured silicone fibers 4 become intertwined, so that a silicone nonwoven fabric 6 is formed continuously along the travel direction 7 of the belt 5.

In those cases where suction is not applied from beneath the belt 5, instead of a silicone nonwoven fabric 6 being formed, the cured silicone fiber 4 that reaches the surface of the belt 5 is collected in a cotton wool-like form on top of the belt 5. The cotton wool-like cured silicone fiber 4 collected in this manner can be used to produce a nonwoven fabric by a papermaking process that employs an aqueous slurry produced from the cured silicone fiber 4 via a wet method.

### [Applications]

A non-melting solid silicone fiber of the present invention can be used as a reinforcing material for a composite material comprising a metal material, a polymer material, or both types of material. Representative examples include composite materials comprising a metal material and a non-melting solid silicone fiber, and composite materials comprising a polymer material and a non-melting solid silicone fiber. Examples of suitable metal materials include light metals such as aluminum and titanium. Examples of suitable polymer materials include polyethylene, polypropylene, polyethylene terephthalate and silicone resins. A composite material of the present invention can be produced by mixing together a metal material and/or a polymer material, with a non-melting solid silicone fiber of the present invention. Usually, the composite material adopts a structure in which the metal material and/or polymer material that functions as the base material forms a matrix, and the non-melting solid silicone fiber is then dispersed within this matrix. The quantity added of the non-melting solid silicone fiber, relative to the combined mass of the composite material, is preferably within a range from 1 to 50% by mass, and is even more preferably from 10 to 30% by mass. Provided the quantity added falls within this range, the strength of the resulting composite material can be more readily ensured.

A silicone nonwoven fabric of the present invention exhibits excellent crack resistance, solvent resistance and heat resistance, and can be used favorably as a substrate for printed wiring boards; a tile carpet, laminated sheet, decorative sheet or other construction material; a separator for a solid electrolytic capacitor; and a separator for a fuel cell.

### EXAMPLES

As follows is a more detailed description of the present invention using a series of examples, although the present invention is in no way limited by these examples. In these examples, molecular weight values are weight average molecular weights measured by GPC and referenced against polystyrene standards. Furthermore, the average elemental ratio between constitutional elements within a fiber is simply referred to as the "elemental ratio". Moreover, "Me" represents a methyl group, "i-Pr" represents an isopropyl group, and "Ph" represents a phenyl group. In the following examples, experiments were conducted at room temperature unless otherwise indicated.

### [Example 1]

A meltable silicone resin comprising only MeSiO_{3/2} units as the siloxane units, and containing 5% by mass of hydroxyl groups (molecular weight: 1,000, average compositional formula: Me(OH)0.2SiO_{1.3}, elemental ratio: SiCH_{3.2}O_{1.5}, softening point: 65°C) (hereinafter, referred to as "meltable silicone resin α") was subjected to melt spinning under an argon gas atmosphere at a temperature within a range from 130 to 140°C, using a monofilament spinning apparatus with an orifice diameter of 0.05 cm. The speed with which the fiber was wound onto the reel was 250 m/minute. In this manner, a melt spun fiber with a diameter of approximately 15 µm was obtained.

The thus obtained melt spun fiber was immersed in a hydrochloric acid solution with a concentration of 20% by mass, and was left to stand for two days at room temperature. The fibers were then washed with water until the waste water reached a pH value of 6, and were subsequently dried by heating at a temperature of approximately 200°C. The diameter of the resulting fibers was 15 µm, indicating essentially no change between the states before and after the non-melting treatment.

### [Example 2]

With the exception of replacing the meltable silicone resin used in the example 1 with a meltable silicone resin containing approximately 60 mol% of MeSiO_{3/2} units and approximately 40 mol% of i-PrSiO_{3/2} units as the siloxane units, and containing 5% by mass of hydroxyl groups (molecular weight: 1,000, average compositional formula: (Me)_{0.6}(i-Pr)_{0.4}(OH)_{0.2}SiO_{1.3,}, elemental ratio: SiC_{1.8}H_{4.8}O_{1.5}, softening point: 75°C) (hereinafter, referred to as "meltable silicone resin β"), a fiber with a diameter of approximately 15 µm was obtained in the same manner as the example 1.

### [Example 3]

With the exceptions of replacing the meltable silicone resin used in the example 1 with a meltable silicone resin containing approximately 60 mol% of PhSiO_{3/2} units, approximately 20 mol% of Ph₂SiO units, and approximately 20 mol% of MeSiO_{3/2} units as the siloxane units, and containing 5% by mass of hydroxyl groups (molecular weight: 1,000, average compositional formula: Ph(Me)_{0.2}(OH)_{0.3}SiO_{1.1}, elemental ratio: SiC_{6.2}H_{5.6}O_{1.4}, softening point: 92°C) (hereinafter, referred to as "meltable silicone resin γ"), and replacing the 20% by mass hydrochloric acid treatment with a 98% by mass sulfuric acid treatment, a fiber with a diameter of approximately 15 µm was obtained in the same manner as the example 1.

### [Example 4]

Using the same meltable silicone resin a as that used in the example 1, fiber spinning was conducted using a melt blow method, under an argon gas atmosphere at a temperature from 130 to 140°C, by discharging the resin at a speed of 50 m/s from a fiber spinning nozzle with a diameter of 500 µm. During collection of the spun fiber on a receiver positioned below the fiber spinning nozzle, suction was conducted from beneath the receiver at a suction speed of 5 m/s, thereby forming a nonwoven fabric. Inspection of the fiber diameter of the nonwoven fabric using a SEM revealed that the fiber within the nonwoven fabric had a diameter of approximately 3 µm, and the thickness of the nonwoven fabric was 1 mm.

### [Example 5]

Using the same meltable silicone resin as that used in the example 3, fiber spinning was conducted using a melt blow method, under an argon gas atmosphere at a temperature from 130 to 140°C, by discharging the resin at a speed of 50 m/s from a fiber spinning nozzle with a diameter of 500 µm. During collection of the spun fiber on a receiver positioned below the fiber spinning nozzle, suction was conducted from beneath the receiver at a suction speed of 5 m/s, thereby forming a nonwoven fabric. Inspection of the fiber diameter of the nonwoven fabric using a SEM revealed that the fiber within the nonwoven fabric had a diameter of approximately 3 µm, and the thickness of the nonwoven fabric was 1 mm.

### [Example 6]

### - Method of Producing Silicone Nonwoven Fabric (1) (Dry Method)

The method is described with reference to Fig. 1. Using a fiber spinning apparatus, the same meltable silicone resin α (2 in Fig. 1) as that used in the example 1, which had been melted at a temperature within a range from 130 to 140°C, was subjected to spinning using a melt blow method under an argon gas atmosphere, by discharging the resin at a speed of 50 m/s from an aperture 3 with a diameter of 500 µm belonging to a fiber spinning nozzle, The spun fiber 4 was collected on the belt 5 of a belt conveyor that was positioned below the nozzle 1 and functioned as a receiver, while the belt 5 was moved in the direction of an arrow 7 at a travel speed of 2 cm/s, and suction was conducted continuously from beneath the belt 5 with a suction speed of 5 m/s. As a result, a nonwoven fabric 6 was formed on top of the belt 5. Inspection of the fiber diameter of the nonwoven fabric using a SEM revealed that the fiber within the nonwoven fabric had a diameter of approximately 3 µm, and the thickness of the nonwoven fabric was 1 mm.

The thus obtained nonwoven fabric was immersed in a hydrochloric acid solution with a concentration of 20% by mass, and was left to stand for two days at room temperature. The nonwoven fabric was then washed with water until the waste water reached a pH value of 6, and was subsequently dried by heating at a temperature of approximately 200°C, and inspection of the shape of the fibers within the fabric before and after heating using a SEM revealed no changes.

### [Example 7]

### - Method of Producing Silicone Nonwoven Fabric (1) (Wet Method)

Using a fiber spinning apparatus, the same meltable silicone resin a (2 in Fig. 1) as that used in the example 1, which had been melted at a temperature within a range from 130 to 140°C, was subjected to spinning using a melt blow method under an argon gas atmosphere, by discharging the resin at a speed of 50 m/s from an aperture 3 with a diameter of 500 µm belonging to a fiber spinning nozzle 1. Because suction was not conducted from beneath the belt 5, a cotton wool-like meltable silicone resin fiber 4 was obtained on the belt 5. The diameter of the cotton wool-like fiber was approximately 3 µm.

10 parts by mass of this cotton wool-like fiber was added to 100 parts by mass of a 1% by mass aqueous solution of carboxymethylcellulose, and the resulting mixture was shaken for 2 hours in a shaker operating at 100 back and forth movements/minute, thereby forming a slurry. Using a 200 mesh strainer, a nonwoven fabric was produced from this slurry by a papermaking process. The thickness of the nonwoven fabric was 0.8 mm.

### [Example 8]

With the exceptions of replacing the meltable silicone resin a used in the example 6 with the same meltable silicone resin y as that used in the example 3, and replacing the 20% by mass hydrochloric acid treatment used in the non-melting treatment with a 98% by mass sulfuric acid treatment, a nonwoven fabric was obtained in the same manner as the example 6. Inspection of the fibers of the nonwoven fabric using a SEM revealed a fiber diameter within the nonwoven fabric of approximately 3 µm, and the thickness of the nonwoven fabric was 1 mm.

### [Example 9]

### - Method of Producing Silicone Nonwoven Fabric (2) (Dry Method)

(a) 90 parts by mass of a diorganopolysiloxane containing vinyl groups bonded to silicon atoms, represented by a formula shown below. 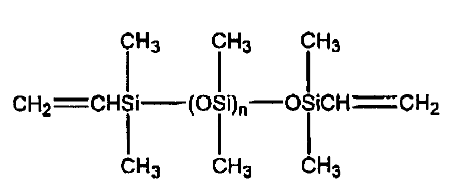 (wherein, n represents a number that yields a viscosity at 25°C for the siloxane of 600 mPa·s)
(b) 10 parts by mass of a diorganopolysiloxane containing hydrogen atoms bonded to silicon atoms, represented by a formula shown below 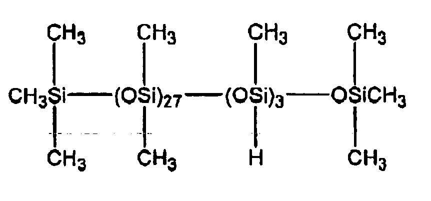
(c) 0.15 parts by mass of a toluene solution of a complex of platinum and divinyltetramethyldisiloxane (platinum element content: 0.5% by mass, a hydrosilylation catalyst)

The above components (a) and (b) were combined in a planetary mixer (a mixing device, manufactured by Inoue Manufacturing Co., Ltd.), and were stirred for one hour at room temperature. Subsequently, the component (c) was added to the planetary mixer and stirring was continued for a further 30 minutes, thus yielding an addition-curable silicone composition.

Using the technique shown in Fig. 2, a silicone nonwoven fabric was formed from this composition. 20 fiber spinning nozzles 1 (cross-sectional shape: circular, internal diameter: 500 µm) were arranged along a single line with a spacing of 1 mm between nozzles. A heating apparatus that functioned as the apparatus 9 was positioned across a range from 10 to 50 cm below the nozzle apertures 3. A horizontal separation of 50 mm was maintained between the falling composition 2a and the apparatus 9. The belt 5 of a belt conveyor was positioned horizontally at a location 100 cm below the nozzle apertures 3. The belt 5 was formed using a rubber with a structure that exhibited air permeability. The belt 5 was moved in the direction of the arrow at a travel speed of 2 cm/s. Suction was conducted from beneath the belt 5 with a suction speed of 5 m/s, thereby forming an airflow which passed through the belt 5 from top to bottom (in the direction of the arrow 8).

The above addition-curable silicone composition was extruded from the fiber spinning nozzles 1 under an argon gas atmosphere, at room temperature, and at a extrusion speed of 50 m/s, and subsequently fell downward, The falling composition was cured by heating to 180°C by the apparatus 9, thereby forming a cured silicone fiber 4. This cured silicone fiber 4 was collected by suction on the surface of the belt 5, thereby intertwining the fibers, and forming a silicone-based nonwoven fabric 6 along the travel direction of the belt 5 (the direction of the arrow 7) in a continuous manner. Measurement of the fiber diameter of the cured silicone fiber within the thus formed nonwoven fabric using a SEM (scanning electron microscope) revealed a diameter of approximately 3 µm. The thickness of the nonwoven fabric was 1 mm. The elemental ratio of the cured silicone fiber was calculated from the elemental composition of the above addition-curable silicone composition to be SiC₂H₆O.

### [Example 10]

### - Method of Producing Silicone Nonwoven Fabric (2) (Wet Method)

With the exception of not conducting the suction from beneath the belt 5, preparation was conducted in the same manner as the example 9, and instead of the silicone nonwoven fabric 6, yielded a cured silicone fiber 4 that was collected in a cotton wool-like form on top of the belt 5. Measurement of the fiber diameter of this fiber using a SEM revealed a result of approximately 3 µm. 10 parts by mass of this fiber was added to 100 parts by mass of a 1% by mass aqueous solution of carboxymethylcellulose, and the resulting mixture was shaken for 2 hours in a shaker operating at 100 back and forth movements/minute, thereby forming a slurry. Using a 200 mesh strainer (prescribed in JIS Z 8801-1), a nonwoven fabric was produced from this slurry by a papermaking process. Measurement of the fiber diameter of the cured silicone fiber within the resulting nonwoven fabric by SEM revealed a result of approximately 3 µm. The thickness of the nonwoven fabric was 0.8 mm.

### [Example 11]

100 parts by mass of an organopolysiloxane represented by a formula shown below, which was liquid at room temperature: 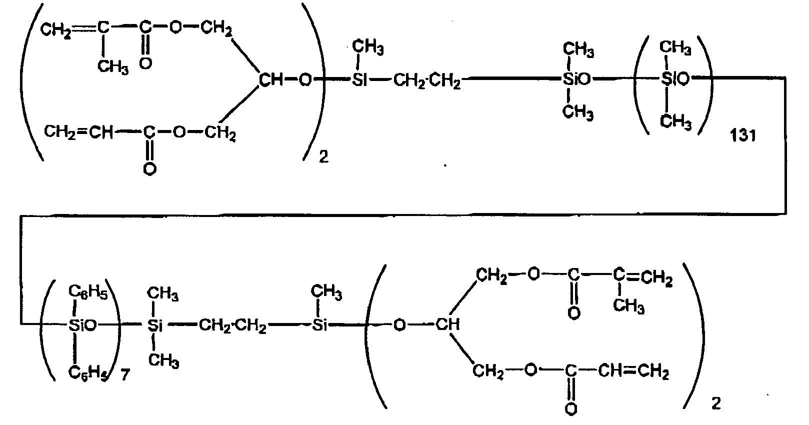 2 parts by mass of 2-hydroxy-2-methyl-1-phenylpropan-1-one, 1 part by mass of 2,4,6-trimethylbenzoyldiphenylphosphine oxide, 1 part by mass of a partial hydrolysis-condensation product of tetramethoxysilane (a methoxysiloxane oligomer), and 0.1 parts by mass of a titanium chelate compound represented by a formula shown below: 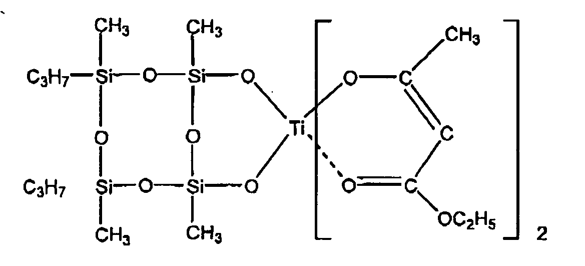 were mixed together, yielding an ultraviolet light-curable silicone composition.

Using the technique shown in Fig. 2, a silicone nonwoven fabric was formed from this composition. 20 fiber spinning nozzles 1 (cross-sectional shape: circular, internal diameter: 500 µm) were arranged along a single line with a spacing of 1 mm between nozzles. Two metal halide mercury lamps (80 W/cm², energy dose: 400 mJ/s) that functioned as the apparatus 9 were positioned across a range from 10 to 50 cm below the nozzle apertures 3. A horizontal separation of 50 mm was maintained between the falling composition 2a and the mercury lamps. The belt 5 of a belt conveyor was positioned horizontally at a location 100 cm below the nozzle apertures 3. A similar belt 5 to that used in the example 9 was used. The belt 5 was moved in the direction of the arrow at a travel speed of 2 cm/s. Suction was conducted from beneath the belt with a suction speed of 5 m/s, thereby forming an airflow which passed through the belt 5 from top to bottom (in the direction of the arrow 8).

The above ultraviolet light-curable silicone composition was extruded from the fiber spinning nozzles 1 under an argon gas atmosphere, at room temperature, and at a extrusion speed of 50 m/s, and subsequently fell downward. The falling composition was cured by irradiation with ultraviolet light from the mercury lamps, thereby forming a cured silicone fiber 4. This cured silicone fiber 4 was collected by suction on the surface of the belt 5, thereby intertwining the fibers, and forming a silicone nonwoven fabric 6 along the travel direction of the belt 5 (the direction of the arrow 7) in a continuous manner. Measurement of the fiber diameter of the cured silicone fiber within the thus formed nonwoven fabric using a SEM revealed a diameter of approximately 3 µm. The thickness of the nonwoven fabric was 1 mm. The elemental ratio of the cured silicone fiber was calculated from the elemental composition of the above ultraviolet light-curable silicone composition to be SiC_{2.8}H_{6.6}O_{1.1}.

### [Example 12]

To 100 parts by mass of a dimethylpolysiloxane with both terminals blocked with trimethoxysiloxy groups, represented by a formula shown below: 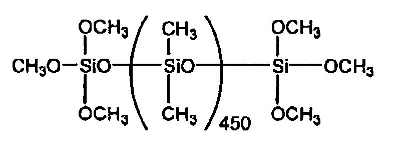 was added 0.1 parts by mass of a titanium chelate catalyst, and the resulting mixture was stirred thoroughly, yielding a condensation-curable silicone composition.

Using the technique shown in Fig. 2, a silicone nonwoven fabric was formed from this composition. 20 fiber spinning nozzles 1 (cross-sectional shape: circular, internal diameter: 500 µm) were arranged along a single line with a spacing of 1 mm between nozzles. A similar heating apparatus to that used in the example 9, which functioned as the apparatus 9, was positioned across a range from 10 to 50 cm below the nozzle apertures 3. A horizontal separation of 50 mm was maintained between the falling composition 2a and the apparatus 9. The belt 5 of a belt conveyor was positioned horizontally at a location 100 cm below the nozzle apertures 3. A similar belt 5 to that used in the example 9 was used. The belt 5 was moved in the direction of the arrow at a travel speed of 2 cm/s. Suction was conducted from beneath the belt 5 with a suction speed of 5 m/s, thereby forming an airflow which passed through the belt 5 from top to bottom (in the direction of the arrow 8).

The above condensation-curable silicone composition was extruded from the fiber spinning nozzles 1 under an argon gas atmosphere (50% RH), at room temperature and at a extrusion speed of 50 m/s, and subsequently fell downward. The falling composition was cured by the moisture in the surrounding environment, thereby forming a cured silicone fiber 4. Furthermore, the composition was also heated to 180°C by the apparatus 9, which further accelerated the curing process. The cured silicone fiber 4 was collected by suction on the surface of the belt 5, thereby intertwining the fibers, and forming a silicone nonwoven fabric 6 along the travel direction of the belt 5 (the direction of the arrow 7) in a continuous manner. Measurement of the fiber diameter of the cured silicone fiber within the thus formed nonwoven fabric using a SEM revealed a diameter of approximately 3 µm. The thickness of the nonwoven fabric was 1 mm. The elemental ratio of the cured silicone fiber was calculated from the elemental composition of the above condensation-curable silicone composition to be SiC₂H₆O.

## Claims

1. A fiber formed of a non-melting solid silicone in which a composition of elements is represented by a formula (1):
SiCₐH_{b}O_{c} (1)
(wherein, a is a number that satisfies: 0.5 ≤ a ≤ 7.0, b is a number that satisfies: 0.5 ≤ b ≤ 8.0, and c is a number that satisfies 1.0 ≤ c ≤ 3.0).

2. The fiber according to claim 1, wherein said non-melting solid silicone is a non-melting silicone resin.

3. The fiber according to claim 1, wherein said non-melting solid silicone is a cured product of a curable silicone composition.

4. A method of producing a fiber formed of a non-melting solid silicone defined in claim 1, comprising the steps of:
melt spinning a meltable silicone resin to obtain a meltable silicone resin fiber, and
subjecting the meltable silicone resin fiber to a non-melting treatment to produce the fiber formed of a non-melting solid silicone as a fiber of a non-melting silicone resin.

5. The method according to claim 4, wherein the meltable silicone resin is represented by an average composition formula (2):
R¹ₘR²ₙ(OR³)ₚ(OH)_{q}SiO_{(4-m-n-p-q)/2} (2)
(wherein, each R¹ represents, independently, a hydrogen atom or a monovalent hydrocarbon group other than an aryl group that includes or does not include a carbonyl group, R² represents an aryl group, R³ represents a monovalent hydrocarbon group of 1 to 4 carbon atoms, m represents a number that satisfies: 0.1 ≤ m ≤ 2, n represents a number that satisfies: 0 ≤ n ≤ 2, p represents a number that satisfies: 0 ≤ p ≤ 1.5, and q represents a number that satisfies: 0 ≤ q ≤ 0.35, provided that p+q > 0 and 0.1 ≤ m+n+p+q ≤ 2.6).

6. The method according to either claim 4 or 5, wherein the melt spinning of the meltable silicone resin is conducted using a melt blow method.

7. The method according to any one of claims 4 through 6, wherein the non-melting treatment of the meltable silicone resin fiber is conducted by treating the meltable silicone resin fiber with an inorganic acid.

8. A method of producing a fiber formed of a non-melting solid silicone defined in claim 1, comprising the steps of:
continuously extruding a curable silicone composition which is liquid at room temperature through an aperture to form a fiber of the curable silicone composition,
drawing out the fiber of the curable silicone composition, and
curing the fiber of the curable silicone composition while the fiber is drawn out to produce the fiber formed of a non-melting solid silicone as a fiber of a cured product of the curable silicone composition.

9. A composite material, comprising either one of, or both, a metal material and a polymer material, together with the fiber of a non-melting solid silicone defined in claim 1 as a reinforcing material.

10. A silicone nonwoven fabric comprising the fiber of a non-melting solid silicone defined in claim 1.

11. The silicone nonwoven fabric according to claim 10, wherein said non-melting solid silicone is a non-melting silicone resin,

12. The silicone nonwoven fabric according to claim 10, wherein said non-melting solid silicone is a cured product of a curable silicone composition.

13. A method of producing the silicone nonwoven fabric defined in claim 10, comprising the steps of:
melt spinning a meltable silicone resin to form a meltable silicone resin fiber,
subjecting the meltable silicone resin fiber to suction collection on a receiver to form a nonwoven fabric, and
subsequently subjecting the nonwoven fabric to a non-melting treatment to form the silicone nonwoven fabric as a fiber of a non-melting .silicone resin.

14. A method of producing the silicone nonwoven fabric defined in claim 10, comprising the steps of:
melt spinning a meltable silicone resin to obtain a meltable silicone resin fiber, subjecting the meltable silicone resin fiber to a non-melting treatment,
dispersing a resulting non-melting silicone resin fiber within an aqueous medium containing a binder to prepare a slurry, and
producing the silicone nonwoven fabric formed of the non-melting silicone resin fiber from the slurry using a papermaking process.

15. A method of producing the silicone nonwoven fabric defined in claim 10, comprising the steps of:
continuously extruding a curable silicone composition which is liquid at room temperature through an aperture to form a fiber of the curable silicone composition,
drawing out the fiber of the curable silicone composition, and
curing the fiber of the curable silicone composition while the fiber is drawn out to obtain a cured silicone fiber, and
subjecting the cured silicone fiber to suction collection on a receiver to form the silicone nonwoven fabric formed of the cured silicone fiber.

16. A method of producing the silicone nonwoven fabric defined in claim 10, comprising the steps of:
continuously extruding a curable silicone composition which is liquid at room temperature through an aperture to form a fiber of the curable silicone composition,
drawing out the fiber of the curable silicone composition, and
curing the fiber of the curable silicone composition while the fiber is drawn out, to obtain a cured silicone fiber,
dispersing the cured silicone fiber within an aqueous medium containing a binder to prepare a slurry, and
producing the silicone nonwoven fabric from the slurry using a papermaking process.

17. The method according to either claim 15 or 16, wherein the curable silicone composition is an addition-curable silicone composition, a photocurable silicone composition, or a condensation-curable silicone composition.

18. A substrate for a printed wiring board, comprising the silicone nonwoven fabric defined in claim 10.

19. A construction material comprising the silicone nonwoven fabric defined in claim 10.

20. A separator for a solid electrolytic capacitor, comprising the silicone nonwoven fabric defined in claim 10.

21. A separator for a fuel cell, comprising the silicone nonwoven fabric defined in claim 10.
